(19) Europäisches Patentamt
European Patent Office
Office européen des brevets

(11) EP 4 180 491 A1

(12) **EUROPEAN PATENT APPLICATION**
published in accordance with Art. 153(4) EPC

(43) Date of publication:
**17.05.2023 Bulletin 2023/20**

(21) Application number: **21836930.4**

(22) Date of filing: **05.07.2021**

(51) International Patent Classification (IPC):
***C09D 11/52*** (2014.01) ***H01B 1/00*** (2006.01)
***H01B 1/22*** (2006.01) ***H01B 13/00*** (2006.01)

(52) Cooperative Patent Classification (CPC):
**C09D 11/52; H01B 1/00; H01B 1/22; H01B 13/00**

(86) International application number:
**PCT/JP2021/025306**

(87) International publication number:
**WO 2022/009838 (13.01.2022 Gazette 2022/02)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **08.07.2020 JP 2020118059**

(71) Applicant: **Daicel Corporation**
**Osaka 530-0011 (JP)**

(72) Inventor: **ITO, Yousuke**
**Tokyo 108-8230 (JP)**

(74) Representative: **Grünecker Patent- und Rechtsanwälte**
**PartG mbB**
**Leopoldstraße 4**
**80802 München (DE)**

# (54) CONDUCTIVE INK

(57) An object of the present disclosure is to provide an electrically conductive ink which can form a wire or the like on a substrate by printing and has excellent adhesion to the substrate. An electrically conductive ink of the present disclosure contains Components (A), (B), (C), and (D) below, and has a ratio of Component (C) to Component (D) (Component (C)/Component (D)) of 1 or greater: Component (A): a surface-modified metal nanoparticle having a configuration in which a surface of metal nanoparticle (Component a-1) is coated with an organic protective agent (Component a-2); Component (B): a solvent; Component (C): polyvinyl acetate; and Component (D): polyvinyl acetal.

EP 4 180 491 A1

## Description

### Technical Field

The present disclosure relates to a novel electrically conductive ink. More particularly, the invention relates to an electrically conductive ink suitable for applications of manufacturing electronic devices using printing methods. The present application claims priority from the Japanese Patent Application No. 2020-118059, filed in Japan on July 8, 2020, the contents of which are incorporated herein by reference.

### Background Art

An electronic device (e.g., an electronic circuit) with a wire, an electrode, or the like (hereinafter, sometimes referred to as "wire or the like") has traditionally been formed by an etching method or the like. However, the production process is complicated, thereby increasing the cost. A method using a highly general-purpose printing technology (e.g., screen printing) has been investigated as an alternative to etching or the like.

Among metals, for example, bulk silver has a high melting point of 962°C, but nano-sized silver particles (silver nanoparticles) fuse together at a temperature of approximately 100°C. Thus, use of such silver nanoparticles can form a wire or the like with excellent electrical conductivity on a general-purpose substrate with low heat resistance. However, the nano-sized metal particles are problematically prone to agglomeration.

Patent Document 1 discloses that an electrically conductive ink including: silver nanoparticles having suppressed aggregation by coating surfaces of the silver nanoparticles with an amine; a binder resin such as ethyl cellulose; and a vehicle composed of a solvent, has excellent dispersion stability of silver nanoparticles, and can be suitably used in applications of direct a wire or the like on a substrate by screen printing, and that a sintered body with excellent electrical conductivity can be obtained by sintering the electrically conductive ink.

### Citation List

#### Patent Document

Patent Document 1: WO 2017/175661

### Summary of Invention

#### Technical Problem

However, in a case where a substrate having excellent solvent resistance and surface smoothness, such as a glass substrate, is used, a wire or the like formed using the electrically conductive ink of Patent Document 1 does not provide an anchoring effect, and thus affords room for improving adhesion with the substrate.

Accordingly, an object of the present disclosure is to provide an electrically conductive ink which can form a wire or the like on a substrate by printing, and has excellent adhesion to the substrate.

Another object of the present disclosure is to provide a method for manufacturing an electronic device using the electrically conductive ink.

Still another object of the present disclosure is to provide an electronic device including a sintered body of the electrically conductive ink.

#### Solution to Problem

As a result of extensive studies to solve the above issues, the inventors of the present disclosure have found that an electrically conductive ink obtained by blending specific resins, that is, polyvinyl acetate and polyvinyl acetal with metal nanoparticles having a surface coated with an organic protective agent and a solvent can form a wire or the like excellent in adhesion to a substrate by printing. The invention of the present disclosure was completed based on these findings.

In the present specification, the "nanoparticle(s)" means particles having a primary particle size (average primary particle size) of 0.1 nm or greater and less than 1000 nm. Note that the particle size is determined by scanning electron microscope (SEM) observation. Also, the boiling point in the present specification is a value under normal pressure (760 mmHg).

That is, the present disclosure provides an electrically conductive ink containing Components (A), (B), (C), and (D) below, wherein a ratio of Component (C) to Component (D) (Component (C)/Component (D)) is 1 or greater:

Component (A): a surface-modified metal nanoparticle having a configuration in which the surface of the metal nanoparticle (Component a-1) is coated with an organic protective agent (Component a-2);
Component (B): a solvent;
Component (C): polyvinyl acetate; and
Component (D): polyvinyl acetal.

The electrically conductive ink preferably contains from 30 to 60 parts by weight of Component (B), from 1 to 5 parts by weight of Component (C), and from 0.1 to 2 parts by weight of Component (D), relative to 100 parts by weight of Component (A).
In the electrically conductive ink, the ratio of Component (C) to Component (D) (Component (C)/Component (D)) is preferably from 1 to 10.
In the electrically conductive ink, Component (a-2) is preferably a compound having at least one type of functional group selected from the group consisting of a carboxyl group, a hydroxyl group, an amino group, a sulfo group, and a thiol group.
In the electrically conductive ink, Component (B) preferably contains a terpene solvent (Component b-1).
In the electrically conductive ink, Component (b-1) is preferably a terpene solvent having a boiling point of 130°C or higher and has a viscosity (at 20°C) from 50 to 250 mPa•s.
In the electrically conductive ink, Component (B) preferably contains a glycol solvent (Component b-2).
In the electrically conductive ink, Component (b-2) preferably includes a solvent selected from the group consisting of a glycol ether solvent and a glycol ester solvent having a boiling point of 130°C or higher.
In the electrically conductive ink, Component (b-2) preferably includes a compound represented by Formula (b-2-1) below:

$$R^{n}\text{-}(O\text{-}R^{13})_m\text{-}OR^{12} \quad (b\text{-}2\text{-}1)$$

where $R^{11}$ and $R^{12}$ are identical or different and represent alkyl or acyl groups, $R^{13}$ represents an alkylene group having from 1 to 6 carbon atoms, and m represents an integer of 1 or greater.
In the electrically conductive ink, a weight average molecular weight of Component (C) is preferably 200,000 or less (according to GPC calibrated with polystyrene standards).
In the electrically conductive ink, a weight average molecular weight of Component (D) is preferably 200,000 or less (according to GPC calibrated with polystyrene standards).
In the electrically conductive ink, Component (D) may contain carboxylic acid-modified polyvinyl acetal.
In the electrically conductive ink, Component (D) may contain polyvinyl butyral.
In the electrically conductive ink, Component (D) may contain carboxylic acid-modified polyvinyl butyral.
The electrically conductive ink may further contain a binder resin (F).
A coating film adhesion obtained by applying the electrically conductive ink to a glass substrate and sintering the electrically conductive ink at 120°C for 30 minutes may be 90% or greater in a tape peeling test (in accordance with JIS K 5600).
In the electrically conductive ink, Component (a-1) is preferably a silver nanoparticle.
The present disclosure also provides a method for producing an electronic device, the method including: applying the electrically conductive ink onto a substrate by a printing method; and sintering the electrically conductive ink.
In the method for manufacturing an electronic device, the printing method may be screen printing.
The present disclosure also provides an electronic device including a sintered body of the electrically conductive ink on a substrate.

Advantageous Effects of Invention

Since the electrically conductive ink of the present disclosure has the configuration described above, it is possible to form, by printing, a wire or the like having excellent adhesion to a substrate, on a substrate having excellent solvent resistance and surface smoothness, such as a glass substrate. Thus, the electrically conductive ink according to the present disclosure can be suitably used in applications of manufacturing electronic components (such as a wire and electrodes) on substrates with excellent solvent resistance and surface smoothness, such as glass substrates, using a printing method.

## Description of Embodiments

### Electrically conductive ink

The electrically conductive ink according to an embodiment of the present disclosure contains Components (A), (B), (C), and (D) below:

Component (A): surface-modified metal nanoparticles having a configuration in which the surfaces of the metal nanoparticles (Component a-1) are coated with an organic protective agent (Component a-2);
Component (B): a solvent;
Component (C): polyvinyl acetate; and
Component (D): polyvinyl acetal.

### Surface-modified metal nanoparticles (A)

Surface-modified metal nanoparticles, as Component (A) in an embodiment of the present disclosure, have a configuration in which the surfaces of the metal nanoparticles (Component a-1) are coated with an organic protective agent (Component a-2). As such, the surface-modified metal nanoparticles in an embodiment of the present disclosure ensure spacing between the metal nanoparticles, and thus agglomeration is suppressed. That is, the surface-modified metal nanoparticles (A) in an embodiment of the present disclosure have excellent dispersibility.
A proportion of the organic protective agent (Component a-2) in the surface-modified metal nanoparticles (A) is approximately from 1 to 20 wt.% (preferably, from 1 to 10 wt.%) of a weight of the metal nanoparticles (Component a-1). Each weight of the metal nanoparticle portion and the surface modification portion in the surface-modified metal nanoparticles can be determined, for example, from the weight loss rate in a certain temperature range by subjecting the surface-modified metal nanoparticles to thermogravimetry.
An average primary particle size of the metal nanoparticles (Component a-1) in the surface-modified metal nanoparticles (A) is, for example, from 0.5 to 100 nm, preferably from 0.5 to 80 nm, more preferably from 1 to 70 nm, and even more preferably from 1 to 60 nm. The average primary particle size is determined by a dynamic light scattering method described in the Examples.
A metal constituting the metal nanoparticles (Component a-1) in the surface-modified metal nanoparticles (A) can be a metal having electrical conductivity, and examples thereof can include gold, silver, copper, nickel, aluminum, rhodium, cobalt, and ruthenium. Silver nanoparticles are preferred as the metal nanoparticles (Component a-1) in an embodiment of the present disclosure, in that they can be mutually fused at a temperature of approximately 100°C to form a wire or the like excellent in adhesion even on a substrate excellent in solvent resistance and surface smoothness such as a glass substrate. Therefore, the surface-modified metal nanoparticles in an embodiment of the present disclosure are preferably surface-modified silver nanoparticles, and the electrically conductive ink according to an embodiment of the present disclosure is preferably a silver ink.
The organic protective agent (Component a-2) in the surface-modified metal nanoparticles (A) is preferably a compound having at least one type of functional group selected from the group consisting of a carboxyl group, a hydroxyl group, an amino group, a sulfo group, and a thiol group, particularly preferably a compound having from 4 to 18 carbon atoms and having at least one type of functional group selected from the group consisting of a carboxyl group, a hydroxyl group, an amino group, a sulfo group, and a thiol group, most preferably a compound having at least an amino group, and especially preferably a compound having from 4 to 18 carbon atoms and having an amino group (i.e., an amine having from 4 to 18 carbon atoms).
As the surface-modified metal nanoparticles (A), for example, the surface-modified silver nanoparticles can be manufactured by a manufacturing method or the like described below.
Solvent (B)
A solvent (B) in an embodiment of the present disclosure is not particularly limited, but preferably contains a terpene solvent (Component b-1) or a glycol solvent (Component b-2), and more preferably contains a terpene solvent (Component b-1) and a glycol solvent (Component b-2). Since the electrically conductive ink according to an embodiment of the present disclosure contains the solvent (B), it is possible to suppress a decrease in printing properties due to volatilization of the solvent, thereby allowing continuous printing.
The terpene solvent (Component b-1) preferably has a boiling point of 130°C or higher (for example, from 130 to 300°C, and preferably from 200 to 300°C).
Furthermore, a viscosity (at 20°C) of the terpene solvent (Component b-1) is, for example, from 50 to 250 mPa•s (particularly preferably from 100 to 250 mPa•s, most preferably from 150 to 250 mPa•s), and the use of the viscosity is preferred in that the viscosity of the obtained electrically conductive ink can be appropriately increased, and thin lines can be drawn with excellent precision. Note that the viscosity of the solvent is a value at 20°C and a shear rate

of 10 (1/s) measured using a rheometer (trade name "Physica MCR301", available from Anton Paar).

Examples of the terpene solvent (Component b-1) include 4-(1'-acetoxy-1'-methylester)-cyclohexanol acetate, 1,2,5,6-tetrahydrobenzyl alcohol, 1,2,5,6-tetrahydrobenzyl acetate, cyclohexyl acetate, 2-methylcyclohexyl acetate; 4-t-butylcyclohexyl acetate, terpineol, dihydroterpineol, dihydroterpinyl acetate, α-terpineol, β-terpineol, γ-terpineol, L-α-terpineol, dihydroterpinyloxyethanol, tarpinyl methyl ether, and dihydroterpinyl methyl ether. One of these can be used alone or two or more in combination. In the present disclosure, for example, the trade names "Terusolve MTPH", "Terusolve IPG", "Terusolve IPG-Ac", "Terusolve IPG-2Ac", "Terpineol C" (mixtures of α-terpineol, β-terpineol, and γ-terpineol, boiling point: 218°C; viscosity: 54 mPa•s), "Terusolve DTO-210", "Terusolve THA-90", "Terusolve THA-70" (boiling point: 223°C, viscosity: 198 mPa•s), "Terusolve TOE-100" (all available from Nippon Terpene Chemicals, Inc.), and the like can be used.

The glycol solvent (Component b-2) in an embodiment of the present disclosure is not particularly limited, but examples thereof include a solvent selected from the group consisting of a glycol ether solvent and a glycol ester solvent having a boiling point of 130°C or higher.

Examples of the glycol ether solvent may include compounds represented by Formula (b-2-1) below:

$$R^{n}\text{-}(O\text{-}R^{13})_m\text{-}OR^{12} \quad \text{(b-2-1)}$$

where $R^{11}$ and $R^{12}$ are identical or different and represent alkyl or acyl groups, $R^{13}$ represents an alkylene group having from 1 to 6 carbon atoms, and m represents an integer of 1 or greater.

Examples of the alkyl groups in $R^{11}$ and $R^{12}$ described above may include linear or branched alkyl groups having from 1 to 10 carbon atoms (preferably, from 1 to 5).

Examples of the acyl groups (RCO-groups) in $R^{11}$ and $R^{12}$ described above may include acyl groups (for example, acetyl groups, propionyl groups, butyryl groups, isobutyryl groups, and pivaloyl groups) in which R described above is a linear or branched alkyl group having from 1 to 10 carbon atoms (preferably, from 1 to 5).

In an embodiment of the present disclosure, among these, a compound in which $R^{11}$ and $R^{12}$ in Formula (b-2-1) are groups different from each other (different alkyl groups, different acyl groups, or an alkyl group and an acyl group) is preferred, and a compound in which $R^{11}$ and $R^{12}$ in Formula (b-2-1) are alkyl groups different from each other is particularly preferred. A compound including a linear or branched alkyl group having from 4 to 10 carbon atoms (preferably from 4 to 6) and a linear or branched alkyl group having from 1 to 3 carbon atoms is most preferred.

Examples of such an alkylene group in $R^{13}$ described above include a methylene group, a methylmethylene group, a dimethylmethylene group, an ethylene group, a propylene group, a trimethylene group, a tetramethylene group, a pentamethylene group, and a hexamethylene group. In an embodiment of the present disclosure, among these, an alkylene group having from 1 to 4 carbon atoms is preferred, and an alkylene group having from 1 to 3 carbon atoms is particularly preferred. An alkylene group having from 2 to 3 carbon atoms is most preferred.

m is an integer of 1 or greater and, for example, an integer from 1 to 8, preferably an integer from 1 to 3, and particularly preferably an integer from 2 to 3.

The boiling point of the compound represented by Formula (b-2-1) is, for example, 130°C or higher (for example, from 130 to 300°C), preferably 170°C or higher, and particularly preferably 200°C or higher.

Examples of the compound represented by Formula (b-2-1) include glycol diether, glycol ether acetate, and glycol diacetate such as ethylene glycol methyl ether acetate (boiling point: 145°C), ethylene glycol-n-butyl ether acetate (boiling point: 188°C), propylene glycol methyl-n-propyl ether (boiling point: 131°C); propylene glycol methyl-n-butyl ether (boiling point: 155°C), propylene glycol methyl isoamyl ether (boiling point: 176°C), propylene glycol diacetate (boiling point: 190°C), propylene glycol methyl ether acetate (boiling point: 146°C), 3-methoxybutyl acetate (boiling point: 171°C), 1,3-butylene glycol diacetate (boiling point: 232°C), 1,4-butanediol diacetate (boiling point: 232°C), 1,6-hexanediol diacetate (boiling point: 260°C), diethylene glycol dimethyl ether (boiling point: 162°C), diethylene glycol diethyl ether (boiling point: 189°C), diethylene glycol dibutyl ether (boiling point: 256°C), diethylene glycol ethyl methyl ether (boiling point: 176°C), diethylene glycol isopropyl methyl ether (boiling point: 179°C), diethylene glycol methyl-n-butyl ether (boiling point: 212°C), diethylene glycol-n-butyl ether acetate (boiling point: 247°C), diethylene glycol ethyl ether acetate (boiling point: 218°C), diethylene glycol butyl ether acetate (boiling point: 246.8°C), dipropylene glycol methyl-isopentyl ether (boiling point: 227°C), dipropylene glycol dimethyl ether (boiling point: 175°C), dipropylene glycol methyl-n-propyl ether (boiling point: 203°C), dipropylene glycol methyl-n-butyl ether (boiling point: 216°C), dipropylene glycol methyl cyclopentyl ether (boiling point: 286°C), dipropylene glycol methyl ether acetate (boiling point: 195°C), triethylene glycol dimethyl ether (boiling point: 216°C), triethylene glycol methyl-n-butyl ether (boiling point: 261°C), tripropylene glycol methyl-n-propyl ether (boiling point: 258°C), tripropylene glycol dimethyl ether (boiling point: 215°C), and tetraethylene glycol dimethyl ether (boiling point: 275°C). One of these can be used alone or two or more in combination.

Further, examples of the glycol ether solvent may include compounds (glycol monoethers) represented by Formula (b-2-1') below:

$R^{14}$-(O-$R^{15}$)$_n$-OH (b-2-1')

where $R^{14}$ represents an alkyl group or an aryl group, $R^{15}$ represents an alkylene group having from 1 to 6 carbon atoms, and n is an integer of 1 or greater).

Examples of the alkyl group in $R^{14}$ described above may include linear or branched alkyl groups having from 1 to 10 carbon atoms (preferably, from 1 to 5). Examples of the aryl group may include aryl groups having from 6 to 10 carbon atoms (for example, phenyl groups).

Examples of the alkylene group in $R^{15}$ described above include linear or branched alkylene groups such as a methylene group, a methylmethylene group, a dimethylmethylene group, an ethylene group, a propylene group, a trimethylene group, a tetramethylene group, a pentamethylene group, and a hexamethylene group. In an embodiment of the present disclosure, among these, an alkylene group having from 1 to 4 carbon atoms is preferred, and an alkylene group having from 1 to 3 carbon atoms is particularly preferred. An alkylene group having from 2 to 3 carbon atoms is most preferred.

n is an integer of 1 or greater and, for example, an integer from 1 to 8, preferably an integer from 1 to 3, and particularly preferably an integer from 2 to 3.

The boiling point of the compound represented by Formula (b-2-1') is, for example, 130°C or higher (for example, from 130 to 310°C), preferably from 130 to 250°C, particularly preferably from 130 to 200°C, most preferably from 130 to 180°C, and especially preferably from 140 to 180°C.

Examples of the compound represented by Formula (b-2-1') include ethylene glycol monomethyl ether (boiling point: 124°C), ethylene glycol monoisopropyl ether (boiling point: 141.8°C), ethylene glycol monobutyl ether (boiling point: 171.2°C), ethylene glycol monoisobutyl ether (boiling point: 160.5°C), ethylene glycol monotert-butyl ether (boiling point: 152°C), ethylene glycol monohexyl ether (boiling point: 208°C), ethylene glycol mono-2-ethyl hexyl ether (boiling point: 229°C), ethylene glycol monophenyl ether (boiling point: 244.7°C), ethylene glycol monobenzyl ether (boiling point: 256°C), diethylene glycol monomethyl ether (boiling point: 194°C), diethylene glycol monobutyl ether (=butyl carbitol, boiling point: 230°C), diethylene glycol monoisobutyl ether (boiling point: 220°C), diethylene glycol monoisopropyl ether (boiling point: 207°C), diethylene glycol monopentyl ether (boiling point: 162°C), diethylene glycol monoisopentyl ether, diethylene glycol monohexyl ether (=hexyl carbitol, boiling point: 259.1°C), diethylene glycol mono-2-ethyl hexyl ether (boiling point: 272°C), diethylene glycol monophenyl ether (boiling point: 283°C), diethylene glycol monobenzyl ether (boiling point: 302°C), triethylene glycol monomethyl ether (boiling point: 249°C), triethylene glycol monobutyl ether (boiling point: 271.2°C), propylene glycol monoethyl ether (boiling point: 132.8°C), propylene glycol monopropyl ether (boiling point: 149°C), propylene glycol monobutyl ether (boiling point: 170°C), dipropylene glycol monomethyl ether (boiling point: 188°C), and 3-methoxy-1-butanol (boiling point: 158°C), dipropylene glycol n-butyl ether (boiling point: 229°C), tripropylene glycol monomethyl ether (boiling point: 242°C), and tripropylene glycol monobutyl ether (boiling point: 274°C). One of these can be used alone or two or more in combination.

Examples of the glycol ester solvent may include compounds represented by Formula (b-2-2) below:

$R^{16}$O-($R^{18}$O)$_m$-$R^{17}$ (b-2-2)

where $R^{16}$ represents a hydrogen atom, an alkyl group, an aryl group, or an acyl group, $R^{17}$ represents an acyl group, $R^{18}$ represents an alkylene group, and m' represents an integer of 1 or greater.

That is, the glycol ester solvent in an embodiment of the present disclosure also includes a glycol ether ester solvent.

Examples of the acyl groups (RCO-groups) in $R^{16}$ and $R^{17}$ described above may include acyl groups (for example, an acetyl group, a propionyl group, a butyryl group, an isobutyryl group, and a pivaloyl group) in which R described above is a linear or branched alkyl group having from 1 to 10 carbon atom(s) (preferably, from 1 to 5 carbon atom(s)).

Examples of the alkyl group of $R^{16}$ include linear or branched alkyl groups having from 1 to 10 (preferably, from 1 to 5) carbon atom(s), such as a methyl group, an ethyl group, a propyl group, and an isopropyl group. Examples of the aryl group include aryl groups having from 6 to 10 carbon atoms (for example, phenyl groups).

Examples of the alkylene group in $R^{18}$ described above include a methylene group, a methylmethylene group, a dimethylmethylene group, an ethylene group, a propylene group, a trimethylene group, a tetramethylene group, a pentamethylene group, and a hexamethylene group. In an embodiment of the present disclosure, among these, an alkylene group having from 1 to 4 carbon atoms is preferred, and an alkylene group having from 1 to 3 carbon atoms is particularly preferred. An alkylene group having from 2 to 3 carbon atoms is most preferred.

The m' is an integer of 1 or greater, and is, for example, an integer from 1 to 8, preferably an integer from 1 to 3, and particularly preferably 1.

Examples of the glycol ester solvent described above include $C_{2-3}$ alkylene glycol $C_{1-10}$ alkyl ether $C_{1-10}$ alkyl esters such as ethylene glycol monomethyl ether acetate, ethylene glycol monobutyl ether acetate, propylene glycol

monomethyl ether acetate, and 3-methoxybutyl acetate; di$C_{2-3}$ alkylene glycol $C_{1-10}$ alkyl ether $C_{1-10}$ alkyl esters such as diethylene glycol-n-butyl ether acetate, diethylene glycol ethyl ether acetate, diethylene glycol butyl ether acetate, and dipropylene glycol methyl ether acetate; $C_{2-3}$ alkylene glycol di$C_{1-10}$ alkyl esters such as propylene glycol diacetate, 1,3-butylene glycol diacetate, and 1,4-butanediol diacetate; ethylene glycol diacetate, diethylene glycol diacetate, dipropylene glycol diacetate, 1,6-hexanediol diacetate (1,6-HDDA, boiling point: 260°C), and 2-ethyl-1,6-hexanediol diacetate. One of these can be used alone or two or more in combination. Among these, it is preferable to appropriately select the kind and the content, and thus the conditions described above are matched.

The electrically conductive ink according to an embodiment of the present disclosure may contain, as a solvent having a boiling point of 130°C or higher, one or more types of other solvents [e.g., ethyl lactate acetate (boiling point: 181°C), tetrahydrofurfuryl acetate (boiling point: 195°C), tetrahydrofurfuryl alcohol (boiling point: 176°C), ethylene glycol (boiling point: 197°C), and the like], in addition to the terpene solvent (b-1) described above and the glycol solvent (b-2) described above. However, the content of such other solvents having a boiling point of 130°C or higher is 30 wt.% or less, preferably 20 wt.% or less, particularly preferably 15 wt.% or less, most preferably 10 wt.% or less, even more preferably 5 wt.% or less, and especially preferably 1 wt.% or less of the total amount of the solvent contained in the electrically conductive ink according to an embodiment of the present disclosure.

Polyvinyl acetate (C)

Component (C) in an embodiment of the present disclosure is polyvinyl acetate (C). The electrically conductive ink of the present disclosure includes the polyvinyl acetate (C) with polyvinyl acetal (D) described below, and thus the metal nanoparticles in the ink can be more firmly adhered to the substrate upon firing of the ink according to an embodiment of the present disclosure.

A weight average molecular weight of the polyvinyl acetate (C) (according to GPC calibrated with polystyrene standards) is not particularly limited, but is preferably 200,000 ($20.0 \times 10^4$) or less, more preferably from 50,000 ($5.0 \times 10^4$) to 180,000 ($18.0 \times 10^4$), and more preferably from 50,000 ($5.0 \times 10^4$) to 150,000 ($15.0 \times 10^4$). When the molecular weight of the polyvinyl acetate (C) is 50,000 ($5.0 \times 10^4$) or greater, it is possible to impart excellent substrate adhesion (particularly, adhesion to a smooth substrate such as a glass substrate) to a sintered body of the electrically conductive ink according to an embodiment of the present disclosure. In addition, when a molecular weight of the polyvinyl acetate (C) is $20.0 \times 10^4$ or less, the electrically conductive ink according to an embodiment of the present disclosure has good applicability, and a sintered body having good electrical conductivity is obtained even by sintering in a short time at a low temperature.

A glass transition temperature (Tg) of the polyvinyl acetate (C) is not particularly limited, and is, for example, from 25 to 35°C, more preferably from 26 to 32°C, and even more preferably from 28 to 30°C. When the glass transition temperature (Tg) of the polyvinyl acetate (C) is within the range described above, it is possible to impart excellent substrate adhesion (particularly, adhesion to a smooth substrate such as a glass substrate) to the sintered body of the electrically conductive ink. Note that the glass transition temperature (Tg) of the polyvinyl acetate (C) can be measured, for example, by differential scanning calorimetry (DSC), dynamic viscoelasticity measurement, and the like.

A viscosity of a 4 wt.% aqueous solution of the polyvinyl acetate (C) (measurement temperature: 20°C) is, for example, from 1.5 to 80 mPa•s, preferably from 5 to 70 mPa•s, and particularly preferably from 10 to 60 mPa•s. When the viscosity of the polyvinyl acetate (C) is within the range described above, it is possible to impart excellent substrate adhesion (particularly, adhesion to a smooth substrate such as a glass substrate) to the sintered body of the electrically conductive ink. The viscosity can be measured using a falling-ball viscometer (e.g., Lovis 2000M) or a rotational viscometer (e.g., Model BM).

The polyvinyl acetate (C) can be manufactured by polymerizing vinyl acetate by a normal method, and commercially available products can be used without particularly limitation.

Polyvinyl acetal (D)

Component (D) in an embodiment of the present disclosure is polyvinyl acetal. The electrically conductive ink of the present disclosure includes the polyvinyl acetal (D) with the polyvinyl acetate (C) described above, and thus the metal nanoparticles in the ink can be more firmly adhered to the substrate upon firing of the ink according to an embodiment of the present disclosure.

The polyvinyl acetal is preferably at least one type selected from polyvinyl acetal and carboxylic acid-modified polyvinyl acetal, and more preferably at least one type selected from polyvinyl butyral and carboxylic acid-modified polyvinyl butyral.

A weight average molecular weight of the polyvinyl acetal (D) (molecular weight according to GPC calibrated with polystyrene standards) is not particularly limited, and is, for example, preferably 200,000 ($20.0 \times 10^4$) or less, more preferably from $0.1 \times 10^4$ to $20.0 \times 10^4$, even more preferably from $0.5 \times 10^4$ to $20.0 \times 10^4$, even more preferably from

0.5 to $10^4$ to 10.0 × $10^4$, most preferably from 0.5 × $10^4$ to 5.0 × $10^4$, and especially preferably from 0.5 × $10^4$ to 3.0 × $10^4$. When the molecular weight of the polyvinyl acetal (D) is 0.1 × $10^4$ or greater, it is possible to impart excellent substrate adhesion (in particular, adhesion to a smooth substrate such as a glass substrate) to the sintered body of the electrically conductive ink containing the polyvinyl acetal (D). In addition, when the molecular weight of the polyvinyl acetal (D) is 20.0 × $10^4$ or less, the electrically conductive ink according to an embodiment of the present disclosure has good applicability, and a sintered body having good electrical conductivity is obtained even by sintering in a short time at a low temperature.

A glass transition temperature (Tg) of polyvinyl acetal (D) is, for example, from 50 to 75°C, more preferably from 55 to 70°C, and even more preferably from 58 to 68°C. When the glass transition temperature (Tg) of the polyvinyl acetal (D) is within the range described above, it is possible to impart excellent substrate adhesion (particularly, adhesion to a smooth substrate such as a glass substrate) to the sintered body of the electrically conductive ink. Note that the glass transition temperature (Tg) of the polyvinyl acetal (D) can be measured, for example, by differential scanning calorimetry (DSC), dynamic viscoelasticity measurement, and the like.

A viscosity of a 10 wt.% ethanol solution of the polyvinyl acetal (D) (measurement temperature: 20°C) is, for example, from 5 to 30 mPa•s, preferably from 7 to 20 mPa•s, and particularly preferably from 9 to 15 mPa•s. When the viscosity of the polyvinyl acetal (D) is within the range described above, it is possible to impart excellent substrate adhesion (particularly, adhesion to a smooth substrate such as a glass substrate) to the sintered body of the electrically conductive ink. The viscosity can be measured using a falling-ball viscometer (e.g., Lovis 2000M) or a rotational viscometer (e.g., Model BM).

The polyvinyl acetal (D) can be manufactured, for example, by reacting an aldehyde with polyvinyl alcohol.

As the polyvinyl acetal (D), for example, trade names "Mowital B14S", "Mowital B 16H", "Mowital B20H " (all available from Kuraray Co., Ltd.), "S-LEC BL-1", "S-LEC BL-10", "S-LEC BL-S", "S-LEC SV-02", "S-LEC SV-05", "S-LEC SV-06", "S-LEC SV-12", "S-LEC SV-22", "S-LEC SV-16", and "S-LEC SV-26" (all available from Sekisui Chemical Co., Ltd.) can be used.

Other Components

The electrically conductive ink according to an embodiment of the present disclosure can contain, in addition to the above components, an additive such as a surface energy modifier, a binder resin, a plasticizer, a leveling agent, an antifoaming agent, or a adhesion imparting agent, as necessary. In an embodiment of the present disclosure, a surface energy modifier (E) and/or a binder resin (F) are/is preferably contained, from the perspective of obtaining an effect of improving adhesion to the substrate and flexibility of a sintered body obtained by applying (or printing) the electrically conductive ink according to an embodiment of the present disclosure onto a substrate having excellent solvent resistance and surface smoothness such as a glass substrate and then sintering the applied electrically conductive ink.

Surface energy modifier (E)

The electrically conductive ink according to an embodiment of the present disclosure preferably contains a surface energy modifier (E), for example, in that the electrically conductive ink is transferred to the substrate well when used in printing, and that the adhesion to the substrate is improved. Note that the electrically conductive ink according to an embodiment of the present disclosure may not contain the surface energy modifier (E).

Examples of the surface energy modifier (E) include a silicone-based surface energy modifier, an acrylic surface energy modifier, a fluorine-based surface energy modifier, and a vinyl-based surface energy modifier. One of these can be used alone or two or more in combination. From the perspective of improving adhesion to the substrate, the silicone-based surface energy modifier is preferred.

Any surface energy modifier may be used as the silicone-based surface energy modifier (E) as long as it has a polyorganosiloxane backbone. The polyorganosiloxane backbone should be a polyorganosiloxane formed of a monofunctional M unit (generally, a unit represented by $R_3SiO_{1/2}$), a difunctional D unit (generally, a unit represented by $R_2SiO_{2/2}$), a trifunctional T unit (generally, a unit represented by $RSiO_{3/2}$), and a tetrafunctional Q unit (generally, a unit represented by $SiO_{4/2}$), but a polyorganosiloxane formed of a D unit is usually used.

Examples of an organic group (R) of the polyorganosiloxane include hydrocarbon groups, alkoxy groups, alkenyloxy groups, aryloxy groups, aralkyloxy groups, acyl groups, acyloxy groups, alkylthio groups, alkenylthio groups, arylthio groups, aralkylthio groups, carboxyl groups, alkoxycarbonyl groups, aryloxycarbonyl groups, aralkyloxycarbonyl groups, epoxy group-containing groups, oxetane ring-containing groups, cyano groups, isocyanate groups, carbamoyl groups, isothiocyanate groups, and substituted amino groups.

Examples of the hydrocarbon group include aliphatic hydrocarbon groups, alicyclic hydrocarbon groups, and aromatic hydrocarbon groups.

Examples of the aliphatic hydrocarbon group include an alkyl group, an alkenyl group, and an alkynyl group.

Examples of the alkyl group include linear or branched $C_{1-20}$ alkyl groups, such as a methyl group, an ethyl group, a propyl group, an isopropyl group, a butyl group, a hexyl group, an octyl group, an isooctyl group, a decyl group, and a dodecyl group (preferably $C_{1-10}$ alkyl groups, and even more preferably $C_{1-4}$ alkyl groups). Examples of the alkenyl group include linear or branched $C_{2-20}$ alkenyl groups, such as a vinyl group, an allyl group, a methallyl group, a 1-propenyl group, an isopropenyl group, a butenyl group, a pentenyl group, and a hexenyl group (preferably a $C_{2-10}$ alkenyl group, and even more preferably a $C_{2-4}$ alkenyl group). Examples of the alkynyl group include linear or branched $C_{2-20}$ alkynyl groups, such as an ethynyl group and a propynyl group (preferably a $C_{2-10}$ alkynyl group, and even more preferably a $C_{2-4}$ alkynyl group).

Examples of the alicyclic hydrocarbon group include $C_{3-12}$ cycloalkyl groups, such as a cyclopropyl group, a cyclobutyl group, a cyclopentyl group, a cyclohexyl group, and a cyclododecyl group (especially, a $C_{5-8}$ cycloalkyl group); $C_{3-12}$ cycloalkenyl groups, such as a cyclohexenyl group; and $C_{4-15}$ crosslinked cyclic hydrocarbon groups, such as a bicycloheptanyl group and a bicycloheptenyl group.

Examples of the aromatic hydrocarbon group include $C_{6-14}$ aryl groups, such as a phenyl group and a naphthyl group (especially, a $C_{6-10}$ aryl group).

Examples of the alkoxy group include linear or branched $C_{1-10}$ alkoxy groups, such as a methoxy group, an ethoxy group, a propoxy group, an isopropyloxy group, a butoxy group, and an isobutyloxy group (preferably a $C_{1-6}$ alkoxy group, and even more preferably a $C_{1-4}$ alkoxy group). Examples of the alkenyloxy group include linear or branched $C_{2-10}$ alkenyloxy groups, such as an allyloxy group (preferably a $C_{2-6}$ alkenyloxy group, and even more preferably a $C_{2-4}$ alkenyloxy group). Examples of the aryloxy group include $C_{6-20}$ aryloxy groups, such as a phenoxy group, a tolyloxy group, and a naphthyloxy group (especially, a $C_{6-14}$ aryloxy group). Examples of the aralkyloxy group include $C_{7-20}$ aralkyloxy groups, such as a benzyloxy group and a phenethyloxy group (particularly, a $C_{7-18}$ aralkyloxy group).

Examples of the acyl group include $C_{1-20}$ acyl groups such as an acetyl group, a propionyl group, a (meth) acryloyl groups, and a benzoyl group (particularly, a $C_{1-12}$ acyl group). Examples of the acyloxy group include $C_{1-20}$ acyloxy groups such as an acetyloxy group, a propionyloxy group, a (meth)acryloyloxy group, and a benzoyloxy group (particularly, a $C_{1-12}$ acyloxy group).

Examples of the alkylthio group include linear or branched $C_{1-6}$ alkylthio groups, such as a methylthio group and an ethylthio group (preferably, a $C_{1-4}$ alkylthio group). Examples of the alkenylthio group include linear or branched $C_{2-6}$ alkenylthio groups, such as an allylthio group (preferably, $C_{2-4}$ alkenylthio group). Examples of the arylthio group include $C_{6-20}$ arylthio groups, such as a phenylthio group, a tolylthio group, and a naphthylthio group (particularly, a $C_{6-14}$ arylthio group). Examples of the aralkylthio group include $C_{6-20}$ aralkylthio groups, such as a benzylthio group and a phenethylthio group (particularly, $C_{7-18}$ aralkylthio group).

Examples of the alkoxycarbonyl group include linear or branched $C_{1-10}$ alkoxy-carbonyl groups, such as a methoxycarbonyl group, an ethoxycarbonyl group, a propoxycarbonyl group, and a butoxycarbonyl group (particularly, a $C_{1-6}$ alkoxy-carbonyl group). Examples of the aryloxycarbonyl group include $C_{6-20}$ aryloxy-carbonyl groups, such as a phenoxycarbonyl group, a tolyloxycarbonyl group, and a naphthyloxycarbonyl group (particularly, a $C_{6-14}$ aryloxy-carbonyl group). Examples of the aralkyloxycarbonyl group include $C_{7-20}$ aralkyloxy-carbonyl groups, such as a benzyloxycarbonyl group (particularly, a $C_{7-18}$ aralkyloxy-carbonyl group).

The epoxy group-containing group may be any group having at least an oxirane ring backbone, and examples thereof include epoxy groups (or oxiranyl groups), 1-methyloxiranyl groups (2-methyloxiran-2-yl groups), glycidyl group-containing groups (e.g., a glycidyl group and a methylglycidyl group (2-methyloxiran-2-yl-methyl group)), and alicyclic epoxy groups (e.g., an epoxycycloalkyl group such as a 3,4-epoxycyclohexyl group, and an alkyl-epoxycycloalkyl group such as a 3,4-epoxy-6 methylcyclohexyl group).

Examples of the oxetane ring-containing group include oxetanyl groups (e.g., an oxetan-3-yl group), and alkyloxetanyl groups (e.g., Ci-io alkyloxetanyloxy groups such as a 3-methyl-3-oxetanyloxy group and a 3-ethyl-3-oxetanyloxy group).

Examples of the substituted amino group include mono- or di-alkylamino groups such as methylamino groups, ethyl amino groups, dimethylamino groups, and diethylamino groups (particularly, mono- or di-$C_{1-6}$ alkylamino groups), and mono- or di-acyl amino groups such as acetylamino groups, propionylamino groups, and benzoylamino groups (particularly, mono- or di-$C_{1-11}$ acyl amino groups).

These organic groups may be groups obtained by combining (bonding) two or more types of organic groups. Examples of the combination of two or more types of organic groups include a combination of an aliphatic hydrocarbon group and an alicyclic hydrocarbon group (a cyclohexylmethyl group, a methylcyclohexyl group, etc.); a combination of an aliphatic hydrocarbon group and an aromatic hydrocarbon [$C_{7-18}$ aralkyl groups such as a benzyl group and a phenethyl group (especially, $C_{7-10}$ aralkyl groups), $C_{6-10}$ aryl-$C_{2-6}$ alkenyl groups such as a cinnamyl group, $C_{1-4}$ alkylsubstituted aryl groups such as a tolyl group, $C_{2-4}$ alkenyl-substituted aryl groups such as a styryl group, etc.]; a combination of an alkoxy group and an aliphatic hydrocarbon group (a methoxyethyl group, etc.); and a combination of an aliphatic hydrocarbon group and an aryloxy group (a methylphenoxy group, etc.).

The organic group may further have a substituent. Examples of the substituent include a halogen atom, an oxo

group, a hydroxy group, a hydroperoxy group, an amino group, and a sulfo group.

Among these organic groups (R) of the polyorganosiloxane, hydrocarbon groups and a combination thereof are often used; a $C_{1-12}$ alkyl group (a $C_{1-4}$ alkyl group or the like), an aryl group, and an aralkyl group are usually used; and a methyl group and a phenyl group (particularly, a methyl group) are widely used. A number of repetitions of siloxane units (a degree of polymerization) is, for example, from 2 to 3000, preferably from 3 to 2000, and even more preferably approximately from 5 to 1000. From the perspective of improving adhesion to the substrate, a silicone-based surface energy modifier having a $C_{7-18}$ aralkyl group (particularly, a $C_{7-10}$ aralkyl group) as R is preferred, and, specifically, an aralkyl-modified polymethylalkylsiloxane is preferred.

Commercially available products can be used as the silicone-based surface energy modifier (E). Examples of commercially available silicone-based surface energy modifiers include surface energy modifiers of BYK series available from BYK Japan KK (e.g., "BYK-300", "BYK-301/302", "BYK-306", "BYK-307", "BYK-310", "BYK-313", "BYK-315", "BYK-315N", "BYK-320", "BYK-322", "BYK-323", "BYK-325", "BYK-326", "BYK-330", "BYK-331", "BYK-333", "BYK-337", "BYK-341", "BYK-342", "BYK-344", "BYK-345/346", "BYK-347", "BYK-348", "BYK-349", "BYK-370", "BYK-375", "BYK-377", "BYK-378", "BYK-UV3500", "BYK-UV3505", "BYK-UV3510", "BYK-UV3530", "BYK-UV3570", "BYK-3575", "BYK-UV3576", "BYK-UV3550", "BYK-UV3565", "BYK-SILCLEAN3700", "BYK-SILCLEAN3701", and "BYK-SILCLEAN3720"); surface energy modifiers of AC series available from Algin Chemie (e.g., "AC FS 180", "AC FS 360", and "AC S 20"); surface energy modifiers of POLYFLOW series available from Kyoeisha Chemical Co., Ltd. (e.g., "POLYFLOW KL-400X", "POLYFLOW KL-400HF", "POLYFLOW KL-401", "POLYFLOW KL-402", "POLYFLOW KL-403", and "POLYFLOW KL-404"); surface energy modifiers of KP series available from Shin-Etsu Chemical Co., Ltd. (e.g., "KP-323", "KP-326", "KP-341", "KP-104", "KP-110", and "KP-112"); surface energy modifiers available from Dow Coming Toray Co., Ltd. (e.g., "LP-7001", "LP-7002", "8032 ADDITIVE", "57 ADDITIVE", "L-7604", "FZ-2110", "FZ-2105", "67 ADDITIVE", "8616 ADDITIVE", "3 ADDITIVE", and "56 ADDITIVE"); and surface energy modifiers of DISPARLON series available from Kusumoto Chemicals, Ltd. (e.g., "UVX-272", "LHP-810", "NSH-8430HF", "1711EF", "1761", "LS-001", "LS-050", "LS-460", "LS-480", "LHP-91", and "LHP-96").

When the electrically conductive ink according to an embodiment of the present disclosure contains the surface energy modifier (E) (e.g., silicone-based surface energy modifier), a content thereof is, for example, approximately from 0.1 to 5.0 wt.%, and preferably from 0.5 to 3.0 wt.% of a total amount of the electrically conductive ink.

When the electrically conductive ink according to an embodiment of the present disclosure contains the surface energy modifier (E) (e.g., silicone-based surface energy modifier), the content thereof is, for example, from 0.5 to 5.0 parts by weight, and preferably from 1.0 to 3.0 parts by weight relative to 100 parts by weight of the surface-modified metal nanoparticles (A).

Binder resin (F)

The electrically conductive ink according to an embodiment of the present disclosure contains the binder resin (F), and thus the viscosity of the electrically conductive ink can be adjusted to a viscosity suitable for the desired printing method. Examples of the binder resin (F) include vinyl chloride-vinyl acetate copolymer resins, polyester resins, acrylic resins, and cellulosic resins. One of these can be used alone or two or more in combination. In an embodiment of the present disclosure, a cellulosic resin having less electrical conductivity is preferably used, and ethyl cellulose is more preferably used. As the binder resin (F), the trade names "ETHOCEL std. 200" and "ETHOCEL std. 300" (both available from The Dow Chemical Company) can be used. The electrically conductive ink according to an embodiment of the present disclosure may not contain the binder resin (F).

When the electrically conductive ink according to an embodiment of the present disclosure contains the binder resin (F) (e.g., cellulosic resin), a content thereof is, for example, approximately from 0.1 to 5.0 wt.%, and preferably from 0.3 to 3.0 wt.% of the total amount of the electrically conductive ink.

Method for manufacturing electrically conductive ink

The electrically conductive ink according to an embodiment of the present disclosure can be manufactured as follows. First, the surface-modified metal nanoparticles (A) are manufactured, for example, through mixing a metal compound and an organic protective agent to form a complex containing the metal compound and the organic protective agent (complex formation), thermally decomposing the complex (thermal decomposition), and, as necessary, washing the reaction product (washing). Then, the electrically conductive ink is manufactured through mixing the obtained surface-modified metal nanoparticles (A) with a solvent (B), polyvinyl acetate (C), polyvinyl acetal (D), and, as necessary, a surface energy modifier (E) and/or a binder resin (F), and other additives (preparation of the electrically conductive ink).

Formation of complex

The formation of the complex is to mix a metal compound and an organic protective agent to form a complex containing the metal compound and the organic protective agent. In an embodiment of the present disclosure, a silver compound is preferably used as the metal compound, because the nano-sized silver particles are fused to each other at a temperature of approximately 100°C, and thus a wire having excellent adhesion can be formed even on a substrate having excellent solvent resistance and surface smoothness such as a glass substrate. Particularly, a silver compound that is readily decomposed upon heating and produces metallic silver is preferably used. Examples of such a silver compound include silver carboxylates, such as silver formate, silver acetate, silver oxalate, silver malonate, silver benzoate, and silver phthalate; silver halides, such as silver fluoride, silver chloride, silver bromide, and silver iodide; and silver sulfate, silver nitrate, and silver carbonate. In an embodiment of the present disclosure, among them, silver oxalate is preferred in that it has a high silver content, can be thermally decomposed without using a reducing agent, and thus an impurity derived from the reducing agent is less likely to be mixed into the electrically conductive ink.

As the organic protective agent, a compound having at least one type of functional group selected from the group consisting of a carboxyl group, a hydroxyl group, an amino group, a sulfo group, and a thiol group, in that the coordination of non-covalent electron pairs in the heteroatom to the metal nanoparticles can exert an effect of strongly suppressing agglomeration between the metal nanoparticles. A compound having from 4 to 18 carbon atoms and having at least one type of functional group selected from the group consisting of a carboxyl group, a hydroxyl group, an amino group, a sulfo group, and a thiol group is particularly preferred.

The organic protective agent is preferably a compound having an amino group, and most preferably a compound having from 4 to 18 carbon atoms and having an amino group, that is, an amine having from 4 to 18 carbon atoms.

The amine is a compound in which at least one hydrogen atom of ammonia is substituted with a hydrocarbon group, and includes a primary amine, a secondary amine, and a tertiary amine. In addition, the amine may be a monoamine or a polyamine, such as a diamine. One of these can be used alone or two or more in combination.

The amine preferably contains at least one selected from a monoamine (1) having 6 or more carbon atoms in total and represented by Formula (a-1) below, where $R^1$, $R^2$, and $R^3$ are identical or different and are hydrogen atoms or monovalent hydrocarbon groups (with the proviso that the case in which $R^1$, $R^2$, and $R^3$ are all hydrogen atoms is omitted); monoamine (2) having 5 or less carbon atoms in total and represented by Formula (a-1) below, where $R^1$, $R^2$, and $R^3$ are identical or different and are hydrogen atoms or monovalent hydrocarbon groups (with the proviso that the case in which $R^1$, $R^2$, and $R^3$ are all hydrogen atoms is omitted); and a diamine (3) having 8 or less carbon atoms in total and represented by Formula (a-2), where $R^4$ to $R^7$ are identical or different and are hydrogen atoms or monovalent hydrocarbon groups, and $R^8$ is a divalent hydrocarbon group; and in particular, preferably contains the monoamine (1) in combination with the monoamine (2) and/or the diamine (3).

[Chem. 1]

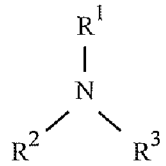

(a-1)

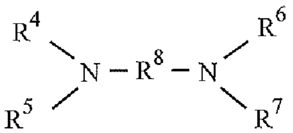

(a-2)

The hydrocarbon group includes an aliphatic hydrocarbon group, an alicyclic hydrocarbon group, and an aromatic hydrocarbon group, and among them, an aliphatic hydrocarbon group or an alicyclic hydrocarbon group is preferred, and in particular, an aliphatic hydrocarbon group is preferred. Thus, the monoamine (1), the monoamine (2), and the diamine (3) are preferably an aliphatic monoamine (1), an aliphatic monoamine (2), and an aliphatic diamine (3).

In addition, the monovalent aliphatic hydrocarbon group includes an alkyl group and an alkenyl group. The monovalent alicyclic hydrocarbon group includes a cycloalkyl group and a cycloalkenyl group. Furthermore, the divalent aliphatic hydrocarbon group includes an alkylene group and an alkenylene group, and the divalent alicyclic hydrocarbon group includes a cycloalkylene group and a cycloalkenylene group.

Examples of the monovalent hydrocarbon group in $R^1$, $R^2$, and $R^3$ may include alkyl groups having approximately

from 1 to 18 carbon atoms, such as a methyl group, an ethyl group, a propyl group, an isopropyl group, a butyl group, an isobutyl group, an sec-butyl group, a tert-butyl group, a pentyl group, a hexyl group, a decyl group, a dodecyl group, a tetradecyl group, an octadecyl group; alkenyl groups having approximately from 2 to 18 carbon atoms, such as a vinyl group, an allyl group, a methallyl group, a 1-propenyl group, an isopropenyl group, a 1-butenyl group, a 2-butenyl group, a 3-butenyl group, a 1-pentenyl group, a 2-pentenyl group, a 3-pentenyl group, a 4-pentenyl group, and a 5-hexenyl group; cycloalkyl groups having approximately from 3 to 18 carbon atoms, such as a cyclopropyl group, a cyclobutyl group, a cyclopentyl group, a cyclohexyl group, and a cyclooctyl group; and cycloalkenyl groups having approximately from 3 to 18 carbon atoms, such as a cyclopentenyl group and a cyclohexenyl group.

Examples of the monovalent hydrocarbon groups in $R^4$ to $R^7$ may include, among those exemplified above, alkyl groups having approximately from 1 to 7 carbon atoms, alkenyl groups having approximately from 2 to 7 carbon atoms, cycloalkyl groups having approximately from 3 to 7 carbon atoms, and cycloalkenyl groups having approximately from 3 to 7 carbon atoms.

Examples of the divalent hydrocarbon group in $R^8$ may include alkylene groups having from 1 to 8 carbon atoms, such as a methylene group, a methylmethylene group, a dimethylmethylene group, an ethylene group, a propylene group, a trimethylene group, a tetramethylene group, a pentamethylene group, and a heptamethylene group; and alkenylene groups having from 2 to 8 carbon atoms, such as a vinylene group, a propenylene group, a 1-butenylene group, a 2-butenylene group, a butadienylene group, a pentenylene group, a hexenylene group, a heptenylene group, and an octenylene group.

The hydrocarbon groups in the above $R^1$ to $R^8$ may have a substituent of various types [e.g., such as a halogen atom, an oxo group, a hydroxyl group, a substituted oxy group (e.g., such as a $C_{1-4}$ alkoxy group, a $C_{6-10}$ aryloxy group, a $C_{7-16}$ aralkyloxy group, or a $C_{1-4}$ acyloxy group), a carboxyl group, a substituted oxycarbonyl group (e.g., such as a $C_{1-4}$ alkoxycarbonyl group, a $C_{6-10}$ aryloxycarbonyl group, or a $C_{7-16}$ aralkyloxycarbonyl group), a cyano group, a nitro group, a sulfo group, or a heterocyclic group]. In addition, the hydroxyl group and the carboxyl group may be protected with a protecting group commonly used in the field of organic synthesis.

The monoamine (1) is a compound that is adsorbed on the surfaces of the metal nanoparticles and prevents agglomeration of the metal nanoparticles and enlargement of the agglomeration, that is, a compound having a function of imparting high dispersibility to the metal nanoparticles. Examples of the monoamine (1) include primary monoamines having a linear alkyl group, such as n-hexylamine, n-heptylamine, n-octylamine, n-nonylamine, n-decylamine, n-undecylamine, and n-dodecylamine; primary amines having a branched alkyl group, such as isohexylamine, 2-ethylhexylamine, and tert-octylamine; a primary amine having a cycloalkyl group, such as cyclohexylamine; a primary amine having an alkenyl group, such as oleylamine; secondary amines having a linear alkyl group, such as N,N-dipropylamine, N,N-dibutylamine, N,N-dipentylamine, N,N-dihexylamine, N,N-dipeptylamine, N,N-dioctylamine, N,N-dinonylamine, N,N-didecylamine, N,N-diundecylamine, N,N-didodecylamine, and N-propyl-N-butylamine; secondary amines having a branched alkyl group, such as N,N-diisohexylamine and N,N-di(2-ethylhexyl)amine; tertiary amines having a linear alkyl group, such as tributylamine and trihexylamine; and tertiary amines having a branched alkyl group, such as triisohexylamine and tri(2-ethylhexyl)amine.

Among the above monoamines (1), an amine (in particular, a primary amine) having a linear alkyl group having from 6 to 18 carbon atoms in total (more preferably up to 16 and particularly preferably up to 12 carbon atoms in total) is preferred in that such an amine can provide space between the metal nanoparticles when the amino groups is adsorbed on the metal nanoparticle surfaces, thus providing the effect of preventing agglomeration of the metal nanoparticles, and such an amine can be easily removed during sintering. In particular, n-hexylamine, n-heptylamine, n-octylamine, n-nonylamine, n-decylamine, n-undecylamine, n-dodedeyclamine, and the like are preferred.

The monoamine (2) has a shorter hydrocarbon chain than that of the monoamine (1), and thus the function of the monoamine (2) itself to impart high dispersibility to the metal nanoparticles is low. However, the monoamine (2) has a high coordination ability to a metal atom due to its higher polarity than that of the monoamine (1), and thus has an effect of promoting complex formation. In addition, the monoamine (2) has a short hydrocarbon chain and thus can be removed from the metal nanoparticle surfaces in a short time (e.g., not longer than 30 minutes and preferably not longer than 20 minutes) even in low-temperature sintering, thus providing a sintered body with excellent electrical conductivity.

Examples of the monoamine (2) include a primary amine having a linear or branched alkyl group and having from 2 to 5 carbon atoms in total (preferably from 4 to 5 carbon atoms in total), such as n-butylamine, isobutylamine, sec-butylamine, tert-butylamine, pentylamine, isopentylamine, and tert-pentylamine; and a secondary amine having a linear or branched alkyl group and having from 2 to 5 carbon atoms in total (preferably from 4 to 5 carbon atoms in total), such as N,N-diethylamine. In an embodiment of the present disclosure, among these, a primary amine having a linear alkyl group and having from 2 to 5 carbon atoms in total (preferably from 4 to 5 carbon atoms in total) is preferred.

The diamine (3) has 8 or less carbon atoms in total and has a high coordination ability to a metal atom due to its higher polarity than that of the monoamine (1), and thus has an effect of promoting complex formation. In addition, the diamine (3) has an effect of promoting thermal decomposition of the complex at lower temperature and in a short time in the thermal decomposition of the complex, and the use of the diamine (3) can perform the production of the

surface-modified metal nanoparticles more efficiently. Furthermore, the surface-modified metal nanoparticles having a configuration of being coated with the protective agent containing the diamine (3) exhibit excellent dispersion stability in a highly polar dispersion medium. Moreover, the diamine (3) has a short hydrocarbon chain and thus can be removed from the metal nanoparticle surfaces in a short time (e.g., not longer than 30 minutes and preferably not longer than 20 minutes) even by low-temperature sintering, thus providing a sintered body with excellent electrical conductivity.

Examples of the diamine (3) may include diamines in which $R^4$ to $R^7$ in Formula (a-2) are hydrogen atoms, and $R^8$ is a linear or branched alkylene group, such as 2,2-dimethyl-1,3-propanediamine, 1,4-butanediamine, 1,5-pentanediamine, 1,6-hexanediamine, 1,7-heptanediamine, 1,8-octanediamine, and 1,5-diamino-2-methylpentane; diamines in which $R^4$ and $R^6$ in Formula (a-2) are identical or different and linear or branched alkyl groups, $R^5$ and $R^7$ are hydrogen atoms, and $R^8$ is a linear or branched alkylene group, such as N,N'-dimethylethylenediamine, N,N'-diethylethylenediamine, N,N'-dimethyl-1,3-propanediamine, N,N'-diethyl-1,3-propanediamine, N,N'-dimethyl-1,4-butanediamine, N,N'-diethyl-1,4-butanediamine, and N,N'-dimethyl-1,6-hexanediamine; and diamines in which $R^4$ and $R^5$ in Formula (a-2) are identical or different and linear or branched alkyl groups, $R^6$ and $R^7$ are hydrogen atoms, and $R^8$ is a linear or branched alkylene group, such as N,N-dimethylethylenediamine, N,N-diethylethylenediamine, N,N-dimethyl-1,3-propanediamine, N,N-diethyl-1,3-propanediamine, N,N-dimethyl-1,4-butanediamine, N,N-diethyl-1,4-butanediamine, and N,N-dimethyl-1,6-hexanediamine.

Among them, diamines in which $R^4$ and $R^5$ in Formula (a-2) above are identical or different and linear or branched alkyl groups, $R^6$ and $R^7$ are hydrogen atoms, and $R^8$ is a linear or branched alkylene group [in particular, diamines in which $R^4$ and $R^5$ in Formula (a-2) are linear alkyl groups, $R^6$ and $R^7$ are hydrogen atoms, and $R^8$ is a linear alkylene group] are preferred.

In diamines in which $R^4$ and $R^5$ in Formula (a-2) are identical or different and are linear or branched alkyl groups, and $R^6$ and $R^7$ are hydrogen atoms, that is, diamines having a primary amino group and a tertiary amino group, the primary amino group has a high coordination ability to a metal atom, but the tertiary amino group has a poor coordination ability to a metal atom, and thus this prevents a resulting complex from becoming excessively complicated, thereby allowing the complex to be thermally decomposed at lower temperature and in a shorter time in the thermal decomposition of the complex. Among them, diamines having 6 or less (e.g., from 1 to 6, preferably from 4 to 6) carbon atoms in total are preferred, and diamines having 5 or less (e.g., from 1 to 5, preferably from 4 to 5) carbon atoms in total are more preferred in that they can be removed from the metal nanoparticle surfaces in a short time in low-temperature sintering.

The proportion of the content of the monoamine (1) in the total amount of the organic protective agent contained in the electrically conductive ink according to an embodiment of the present disclosure, and the proportion of the total content of the monoamine (2) and the diamine (3) therein are preferably within the ranges described below.

Content of monoamine (1): for example, from 5 to 65 mol% (the lower limit is preferably 10 mol%, particularly preferably 20 mol%, and most preferably 30 mol%. In addition, the upper limit is preferably 60 mol%, and particularly preferably 50 mol%)

Total content of monoamine (2) and diamine (3): for example, from 35 to 95 mol% (the lower limit is preferably 40 mol%, and particularly preferably 50 mol%. In addition, the upper limit is preferably 90 mol%, particularly preferably 80 mol%, and most preferably 70 mol%)

The proportion of the content of the monoamine (2) in the total amount of the organic protective agent contained in the electrically conductive ink according to an embodiment of the present disclosure, and the proportion of the content of the diamine (3) therein are preferably within the ranges described below.

Content of monoamine (2): for example, from 5 to 65 mol% (the lower limit is preferably 10 mol%, particularly preferably 20 mol%, and most preferably 30 mol%. In addition, the upper limit is preferably 60 mol%, and particularly preferably 50 mol%)

Content of diamine (3): for example, from 5 to 50 mol% (the lower limit is preferably 10 mol%. In addition, the upper limit is preferably 40 mol%, and particularly preferably 30 mol%)

The monoamine (1) contained in the above range provides dispersion stability of the metal nanoparticles. With the content of the monoamine (1) below the above range, the metal nanoparticles would tend to be prone to agglomeration. On the other hand, the content of the monoamine (1) exceeding the above range would cause difficulty in removing the organic protective agent from the metal nanoparticle surfaces in a short time when the sintering temperature is low, tending to reduce the electrical conductivity of the resulting sintered body.

The monoamine (2) contained in the above range provides the effect of promoting complex formation. In addition, this allows the organic protective agent to be removed from the metal nanoparticle surfaces in a short time even when the sintering temperature is low, providing a sintered body with excellent electrical conductivity.

The diamine (3) contained in the above range easily provides the effect of promoting complex formation and the effect of promoting the thermal decomposition of the complex. In addition, the surface-modified metal nanoparticles having a configuration of being coated with the protective agent containing the diamine (3) exhibit excellent dispersion stability in a highly polar dispersion medium.

In an embodiment of the present disclosure, the use of the monoamine (2) and/or the diamine (3) having a high

coordination ability to metal atoms of the metal compound is preferred, in that the use can reduce the amount of the monoamine (1) used depending on the proportion of the monoamine (2) and/or the diamine (3) used and can remove the organic protective agent from the metal nanoparticle surfaces in a short time even when the sintering temperature is low, providing a sintered body with excellent electrical conductivity.

The amine used as the organic protective agent in an embodiment of the present disclosure may contain an additional amine other than the monoamine (1), the monoamine (2), and the diamine (3), but the proportion of the total content of the monoamine (1) and the monoamine (2), and the diamine (3) accounting for the total amines contained in the protective agent is, for example, preferably from 60 wt.% or greater, particularly preferably 80 wt.% or greater, and most preferably 90 wt.% or greater. Note that the upper limit is 100 wt.%. That is, the content of the additional amine is preferably not greater than 40 wt.%, particularly preferably not greater than 20 wt.%, and most preferably not greater than 10 wt.%.

The amount of the organic protective agent [in particular, monoamine (1) + monoamine (2) + diamine (3)] used is not particularly limited but is preferably approximately from 1 to 50 mol, particularly preferably from 2 to 50 mol, and most preferably from 6 to 50 mol, relative to 1 mol of metal atoms in the metal compound of the raw material. When the amount of the organic protective agent is below the above range, the metal compound not converted to a complex would be prone to remain in the formation of the complex, tending to be difficult to impart sufficient dispersibility to the metal nanoparticles.

In an embodiment of the present disclosure, to further improve the dispersibility of the metal nanoparticles, one or more types of compounds having a carboxyl group (for example, compounds having from 4 to 18 carbon atoms and having a carboxyl group, preferably aliphatic monocarboxylic acids having from 4 to 18 carbon atoms) may be contained together with the compound having an amino group as the organic protective agent.

Examples of the aliphatic monocarboxylic acid may include saturated aliphatic monocarboxylic acids having 4 or more carbon atoms, such as butanoic acid, pentanoic acid, hexanoic acid, heptanoic acid, octanoic acid, nonanoic acid, decanoic acid, undecanoic acid, dodecanoic acid, tridecanoic acid, tetradecanoic acid, pentadecanoic acid, hexadecanoic acid, heptadecanoic acid, octadecanoic acid, nonadecanoic acid, and icosanoic acid; and unsaturated aliphatic monocarboxylic acids having 8 or more carbon atoms, such as oleic acid, elaidic acid, linoleic acid, palmitoleic acid, and eicosenoic acid.

Among them, saturated or unsaturated aliphatic monocarboxylic acids having from 8 to 18 carbon atoms (in particular, octanoic acid and oleic acid) are preferred. When the carboxyl groups of the aliphatic monocarboxylic acid is adsorbed on the metal nanoparticle surfaces, the saturated or unsaturated aliphatic hydrocarbon chain having from 8 to 18 carbon atoms causes a steric hindrance and thus can provide space between the metal nanoparticles, thus improving the effect of preventing agglomeration of the metal nanoparticles.

The amount of the compound having a carboxyl group used is, for example, approximately from 0.05 to 10 mol, preferably from 0.1 to 5 mol, and particularly preferably from 0.5 to 2 mol, relative to 1 mol of metal atoms in the metal compound. The amount of the compound having a carboxyl group used below the above range would cause difficulty in providing an effect of improving dispersion stability. On the other hand, the compound having a carboxyl group, even when used in an excessive amount, would saturate the effect of improving the dispersion stability while it tends to be difficult to remove the compound by low-temperature sintering.

The reaction between the organic protective agent and the metal compound is performed in the presence or absence of the dispersion medium. As the dispersion medium, for example, an alcohol having 3 or more carbon atoms can be used.

Examples of the alcohol having 3 or more carbon atoms include n-propanol (boiling point: 97°C), isopropanol (boiling point: 82°C), n-butanol (boiling point: 117°C), isobutanol (boiling point: 107.89°C), sec-butanol (boiling point: 99.5°C), tert-butanol (boiling point: 82.45°C), n-pentanol (boiling point: 136°C), n-hexanol (boiling point: 156°C), n-octanol (boiling point: 194°C), and 2-octanol (boiling point: 174°C). Among them, alcohols having from 4 to 6 carbon atoms are preferred, and in particular, n-butanol and n-hexanol are preferred in that higher temperature can be set for the thermal decomposition of the complex to be performed later and in terms of the convenience of the post-treatment of the resulting surface-modified metal nanoparticles.

In addition, the amount of the dispersion medium used is, for example, not less than 120 parts by weight, preferably not less than 130 parts by weight, and more preferably not less than 150 parts by weight, relative to 100 parts by weight of the metal compound. The upper limit of the amount of the dispersion medium used is, for example, 1000 parts by weight, preferably 800 parts by weight, and particularly preferably 500 parts by weight.

The reaction between the organic protective agent and the metal compound is preferably performed at ordinary temperature (from 5 to 40°C). The reaction is accompanied by heat generation due to the coordination reaction of the organic protective agent to the metal compound and thus may be performed while the reaction mixture is appropriately cooled to the above temperature range.

The reaction time between the organic protective agent and the metal compound is, for example, approximately from 30 minutes to 3 hours. This results in a metal-organic protective agent complex (metal-amine complex when an

amine is used as the organic protective agent).

Thermal decomposition

The thermal decomposition is a step of thermally decomposing the resulting metal-organic protective agent complex through the formation of the complex to form the surface-modified metal nanoparticles. It is believed that the metal-organic protective agent complex is heated to cause thermal decomposition of the metal compound to form metal atoms while maintaining coordination bonding of the organic protective agent to the metal atoms, and then agglomeration of the metal atoms to which the organic protective agent is coordinated, leading to formation of metal nanoparticles that are coated with an organic protective film.

The thermal decomposition is preferably performed in the presence of a dispersion medium, and the alcohol described above can be suitably used as the dispersion medium. In addition, the thermal decomposition temperature is to be a temperature at which the surface-modified metal nanoparticles are formed, and when the metal-organic protective agent complex is a silver oxalate-organic protective agent complex, the temperature is, for example, approximately from 80 to 120°C, preferably from 95 to 115°C, and particularly preferably from 100 to 110°C. In terms of preventing the elimination of the surface modification portion of the surface-modified metal nanoparticle, the thermal decomposition is preferably performed at a temperature as low as possible within the above temperature range. The thermal decomposition duration is, for example, approximately from 10 minutes to 5 hours.

In addition, the thermal decomposition of the metal-organic protective agent complex is preferably performed in an air atmosphere or in an inert gas atmosphere, such as argon.

Washing Step

The excess organic protective agent, if present after the completion of the thermal decomposition reaction of the metal-organic protective agent complex, is preferably removed by decantation, which may be repeated once or more times as necessary. In addition, the surface-modified metal nanoparticles after the completion of the decantation is preferably subjected to the preparation of the electrically conductive ink described below in a wet state without drying or solidifying in that this can prevent re-agglomeration of the surface-modified metal nanoparticles and maintain high dispersibility.

Decantation is performed, for example, by washing the surface-modified metal nanoparticles in a suspended state with a cleaning agent, precipitating the surface-modified metal nanoparticles by centrifugation, and removing the supernatant. The cleaning agent used is preferably one or more types of linear or branched alcohols having from 1 to 4 (preferably from 1 to 2) carbon atoms, such as methanol, ethanol, n-propanol, or isopropanol in terms of achieving good precipitation of the surface-modified metal nanoparticles and efficiently separating and removing the cleaning agent by centrifugation after the washing.

Preparation of electrically conductive ink

The preparation of the electrically conductive ink is to prepare the electrically conductive ink according to an embodiment of the present disclosure by mixing the surface-modified metal nanoparticles (A) (preferably the surface-modified metal nanoparticles (A) in a wet state) obtained through the above processes, a solvent (B), polyvinyl acetate (C), polyvinyl acetal (D), and, as necessary, a surface energy modifier (E) and/or a binder resin (F), and other additive. For the mixing, a commonly known mixing apparatus, such as, for example, a self-rotating stirring defoaming apparatus, a homogenizer, a planetary mixer, a three-roll mill, or a bead mill, can be used. In addition, each component may be mixed at the same time or sequentially. The mixing portion of each component can be appropriately adjusted in the range described below.

The mixing portion of each component can be appropriately adjusted in a range where the electrically conductive ink with the composition described below is obtained.

A content of the surface-modified metal nanoparticles (A) in the total amount of the electrically conductive ink (100 wt.%) according to an embodiment of the present disclosure is not particularly limited, and is, for example, from 60 to 85 wt.%, and a lower limit thereof is preferably 70 wt.% in that the effect of improving adhesion to the substrate is obtained. The upper limit of the content is preferably 80 wt.% and particularly preferably 75 wt.%.

A content of the solvent (B) in the total amount of the electrically conductive ink (100 wt.%) according to an embodiment of the present disclosure is not particularly limited, and is, for example, from 5 to 45 wt.%, and a lower limit thereof is preferably 10 wt.%, and more preferably 20 wt.%. An upper limit of the content is preferably 40 wt.% and particularly preferably 35 wt.%. The solvent (B) contained in the range described above can provide the effect of suppressing bleeding and improving the drawing accuracy of thin lines and the effect of improving the continuous printing properties.

The content of the solvent (B) in the electrically conductive ink according to an embodiment of the present disclosure is not particularly limited, and is, for example, from 30 to 60 parts by weight relative to 100 parts by weight of the surface-modified metal nanoparticles (A), and a lower limit thereof is preferably 31 parts by weight, and more preferably 33 parts by weight. An upper limit of the content is preferably 50 parts by weight and particularly preferably 45 parts by weight. The solvent (B) contained in the range described above can provide the effect of suppressing bleeding and improving the drawing accuracy of thin lines and the effect of improving the continuous printing properties.

A content of the terpene solvent (Component b-1) in the total amount of the electrically conductive ink (100 wt.%) according to an embodiment of the present disclosure is not particularly limited, and is, for example, from 5 to 30 wt.%, and a lower limit thereof is preferably 10 wt.%, and more preferably 14 wt.%. An upper limit of the content is preferably 25 wt.% and more preferably 23 wt.%. The terpene solvent contained in the range described above can provide the effect of suppressing bleeding and improving the drawing accuracy of thin lines and the effect of improving the continuous printing properties.

The content of the terpene solvent (Component b-1) in the electrically conductive ink according to an embodiment of the present disclosure is not particularly limited, and is, for example, from 10 to 50 parts by weight relative to 100 parts by weight of the surface-modified metal nanoparticles (A), and a lower limit thereof is preferably 15 parts by weight, and more preferably 20 parts by weight. An upper limit of the content is preferably 40 parts by weight and more preferably 35 parts by weight. The terpene solvent (Component b-1) contained in the range described above can provide the effect of suppressing bleeding and improving the drawing accuracy of thin lines and the effect of improving the continuous printing properties.

A content of the glycol solvent (Component b-2) (In particular, compound represented by Formula (b-2-1)) in the total amount (100 wt.%) of the electrically conductive ink according to an embodiment of the present disclosure is not particularly limited, and is, for example, from 1 to 15 wt.%, and a lower limit thereof is preferably 2 wt.% and more preferably 5 wt.%. An upper limit of the content is preferably 10 wt.% and more preferably 8 wt.%. The glycol solvent (Component b-2) (particularly, compound represented by Formula (b-2-1)) contained in the above range can impart thixotropy, make the edge of a drawing part sharper, and improve the printing accuracy. In addition, the effect of improving continuous printing properties can also be obtained.

The content of the glycol solvent (Component b-2) (particularly, compound represented by Formula (b-2-1)) in the electrically conductive ink according to an embodiment of the present disclosure is not particularly limited, and is, for example, from 1 to 20 parts by weight relative to 100 parts by weight of the surface-modified metal nanoparticles (A), and a lower limit thereof is preferably 2 parts by weight, and more preferably 5 parts by weight. An upper limit of the content is preferably 15 parts by weight and more preferably 12 parts by weight. The glycol solvent (Component b-2) (particularly, compound represented by Formula (b-2-1)) contained in the above range can impart thixotropy, make the edge of a drawing part sharper, and improve the printing accuracy. In addition, the effect of improving continuous printing properties can also be obtained.

Additionally, the electrically conductive ink according to an embodiment of the present disclosure can contain the compound represented by Formula (b-2-1') in an amount of, for example (without particular limitation), 10 wt.% or less (from 5 to 10 wt.%), and preferably 8.5 wt.% or less of the total amount of the ink.

A ratio of the terpene solvent (Component b-1) to the glycol solvent (Component b-2) (terpene solvent (Component b-1)/glycol solvent (Component b-2)) in the electrically conductive ink according to an embodiment of the present disclosure is not particularly limited, and is, for example, from 0.1 to 10, and a lower limit thereof is preferably from 0.5, more preferably 1, and even more preferably 2. An upper limit of the ratio is preferably 8, more preferably 7, and even more preferably 5. By adjusting the ratio of the terpene solvent (Component b-1) to the glycol solvent (Component b-2) to the range described above, the effect of improving the drawing accuracy of the thin wire and the effect of improving the continuous printing properties can be obtained. Further, the edge of the drawing part can be made sharper, and the printing accuracy can be improved. In addition, the effect of improving continuous printing properties can also be obtained.

Furthermore, the electrically conductive ink according to an embodiment of the present disclosure may also contain a solvent having a boiling point of lower than 130°C [for example, ethylene glycol dimethyl ether (boiling point: 85°C), propylene glycol monomethyl ether (boiling point: 120°C), and propylene glycol monomethyl ether (boiling point: 97°C)]. The content of the solvent having a boiling point of lower than 130°C (total amount, if two or more types are contained) in the total amount of the electrically conductive ink according to an embodiment of the present disclosure (100 wt.%) is 20 wt.% or less, preferably 10 wt.% or less, particularly preferably 5 wt.% or less, and most preferably 1 wt.% or less. In the electrically conductive ink according to an embodiment of the present disclosure, the content of the solvent having a boiling point of lower than 130°C is suppressed to the range described above, and thus clogging caused by volatilization of the solvent can be suppressed, and continuous printing is thus possible.

A content of the polyvinyl acetate (C) in the total amount of the electrically conductive ink according to an embodiment of the present disclosure (100 wt.%) is not particularly limited, and is, for example, from 0.1 to 10 wt.%, and a lower limit thereof is preferably 0.5 wt.%, and more preferably 1 wt.%. An upper limit of the content is preferably 5 wt.% and particularly preferably 3 wt.%. The polyvinyl acetate (C) contained in the above range provides the effect of

improving adhesion to a substrate having excellent solvent resistance and surface smoothness such as a glass substrate.

The content of the polyvinyl acetate (C) in the electrically conductive ink of the present disclosure is not particularly limited, and is, for example, from 0.5 to 5 parts by weight relative to 100 parts by weight of the surface-modified metal nanoparticles (A), and a lower limit thereof is preferably 1 part by weight, and more preferably 1.3 parts by weight. An upper limit of the content is preferably 4 parts by weight and particularly preferably 3 parts by weight. The polyvinyl acetate (C) contained in the above range provides the effect of improving adhesion to a substrate having excellent solvent resistance and surface smoothness such as a glass substrate.

A content of the polyvinyl acetal (D) in the total amount of the electrically conductive ink according to an embodiment of the present disclosure (100 wt.%) is not particularly limited, and is, for example, from 0.1 to 5 wt.%, and a lower limit thereof is preferably 0.2 wt.%, more preferably 0.3 wt.%. An upper limit of the content is preferably 3 wt.% and particularly preferably 1 wt.%. The polyvinyl acetal (D) contained in the above range provides the effect of improving adhesion to a substrate having excellent solvent resistance and surface smoothness such as a glass substrate.

The content of the polyvinyl acetal (D) in the electrically conductive ink according to an embodiment of the present disclosure is not particularly limited, and is, for example, from 0.1 to 2 parts by weight relative to 100 parts by weight of the surface-modified metal nanoparticles (A), and a lower limit thereof is preferably 0.3 parts by weight, and more preferably 0.5 parts by weight. An upper limit of the content is preferably 1.5 parts by weight and particularly preferably 1 part by weight. The polyvinyl acetal (D) contained in the above range provides the effect of improving adhesion to a substrate having excellent solvent resistance and surface smoothness such as a glass substrate.

In the electrically conductive ink according to an embodiment of the present disclosure, the ratio of the polyvinyl acetate (C) to the polyvinyl acetal (D) (polyvinyl acetate (C)/polyvinyl acetal (D)) is 1 or greater (e.g., from 1 to 10), and a lower limit thereof is preferably 1.3, and further preferably 1.5. An upper limit of the ratio is preferably 7 and more preferably 5. The ratio of the polyvinyl acetate (C) to the polyvinyl acetal (D) adjusted to the above range provides the effect of improving adhesion to a substrate having excellent solvent resistance and surface smoothness such as a glass substrate.

A viscosity (at 25°C and a shear rate of 10 (1/s)) of the electrically conductive ink according to an embodiment of the present disclosure is not particularly limited, and is, for example, 60 Pa•s or greater, preferably 70 Pa•s or greater, more preferably 80 Pa•s or greater, even more preferably 90 Pa s or greater, even more preferably 100 Pa s or greater, and particularly preferably 150 Pa•s or greater. The upper limit of the viscosity is, for example, approximately 500 Pa•s, preferably 450 Pa•s, particularly preferably 400 Pa•s, and most preferably 350 Pa•s.

A viscosity (at 25°C and a shear rate of 100 (1/s)) of the electrically conductive ink according to an embodiment of the present disclosure is not particularly limited, and is, for example, from 10 to 100 Pa•s, and an upper limit thereof is preferably 80 Pa•s, particularly preferably 60 Pa•s, most preferably 50 Pa•s, and especially preferably 40 Pa•s. The lower limit of the viscosity is preferably 15 Pa•s, particularly preferably 20 Pa•s, most preferably 25 Pa•s, and especially preferably 30 Pa•s.

The electrically conductive ink according to an embodiment of the present disclosure preferably has thixotropy, and the TI value at 25°C (viscosity at a shear rate of 10 (1/s)/viscosity at a shear rate of 100 (1/s)) is not particularly limited, and is preferably in a range of for example from 3.0 to 10.0, preferably from 3.5 to 7.0, particularly preferably from 4.0 to 6.5, most preferably from 4.5 to 6.3, and especially preferably from 4.8 to 6.2.

The electrically conductive ink according to an embodiment of the present disclosure is excellent in dispersion stability, and, for example, when an electrically conductive ink having a silver concentration of 65 wt.% is stored at 5°C, an increase in viscosity can be suppressed in a period of 1 month or longer.

Method for producing electronic device

A method for manufacturing an electronic device according to an embodiment of the present disclosure includes applying the ink onto a substrate by a printing method; and sintering the ink.

The desired printing method is not particularly limited, and, for example, screen printing, offset printing, flexographic printing, gravure printing, inkjet printing, and screen printing are preferred.

In the method for manufacturing an electronic device according to an embodiment of the present disclosure, the electrically conductive ink is used, and thus sintering can be performed at low temperatures. A sintering temperature is not particularly limited, and is, for example, 130°C or lower (a lower limit of the sintering temperature is, for example, 60°C, and is more preferably 100°C in that the sintering can be performed in a short period of time), and particularly preferably 120°C or lower. The sintering time is, for example, from 0.5 to 3 hours, preferably from 0.5 to 2 hours, and particularly preferably from 0.5 to 1 hour.

Using the electrically conductive ink according to an embodiment of the present disclosure allows sintering of the surface-modified metal nanoparticles (A) to sufficiently proceed even through low-temperature sintering (e.g., sintering at low temperature and in a short period of time). As a result, a sintered body having excellent electrical conductivity, i.e., a volume resistivity of, for example, 20 μΩm or less, preferably 15 S2m or less, and particularly preferably 10 μΩ

cm or less. The conductivity (or volume resistivity) of the sintered body can be measured by the method described in Examples.

Using the electrically conductive ink according to an embodiment of the present disclosure enables low-temperature sintering as described above, and thus the substrate is not particularly limited, and can be, for example, a glass substrate and a heat-resistant plastic substrate (such as a polyimide-based film); a polyester-based film (such as a polyethylene terephthalate (PET) film or a polyethylene naphthalate (PEN) film); or a polyolefin-based film (such as a polypropylene film).

The use of the electrically conductive ink according to an embodiment of the present disclosure makes it possible to form a sintered body having excellent adhesion even to a substrate having excellent solvent resistance and surface smoothness (such as a glass substrate) as described above. Although not particularly limited, for example, the coating film adhesion obtained by sintering performed on a glass sheet at 120°C for 30 minutes is 90% or greater, and preferably 95% or greater in a tape peeling test (according to JIS K 5600).

Electronic devices obtained by the method for manufacturing an electronic device according to an embodiment of the present disclosure include, but are not limited to, liquid crystal displays, organic EL displays, field emission displays (FED), IC cards, IC tags, solar cells, LED elements, organic transistors, condensers (capacitors), electronic paper, flexible batteries, flexible sensors, membrane switches, touch screens, and EMI shields.

Each aspect disclosed in the present specification can be combined with any other feature disclosed herein.

## Examples

Hereinafter, although the present disclosure will be described in more detail by way of examples, each of the configurations, combinations thereof, and the like in each example are an example, and various additions, omissions, substitutions, and other changes may be made as appropriate without departing from the spirit of the invention of the present disclosure. The present disclosure is not limited by the examples and is limited only by the claims.

### Preparative Example 1 (Preparation of surface-modified silver nanoparticles (1))

Silver oxalate (molecular weight: 303.78) was obtained from silver nitrate (available from Wako Pure Chemical Industries, Ltd.) and oxalic acid dihydrate (available from Wako Pure Chemical Industries, Ltd.).

Then, 40.0 g (0.1317 mol) of the silver oxalate was charged to a 500-mL flask, 60 g of n-butanol was added to this, and an n-butanol slurry of silver oxalate was prepared. To this slurry, an amine mixed liquid of 115.58 g (1.5802 mol) of n-butylamine (molecular weight: 73.14, reagent available from Tokyo Chemical Industry Co., Ltd.), 51.06 g (0.3950 mol) of 2-ethylhexylamine (molecular weight: 129.25, reagent available from Wako Pure Chemical Industries, Ltd.), and 17.02 g (0.1317 mol) of n-octylamine (molecular weight: 129.25, reagent available from Tokyo Chemical Industry Co., Ltd.) was added dropwise at 30°C. After the dropwise addition, the mixture was stirred at 30°C for 1 hours to allow a complex forming reaction between silver oxalate and the amines to proceed. After the formation of the silver oxalate-amine complex, the silver oxalate-amine complex was thermally decomposed by heating at 110°C for 1 hour to obtain a dark blue suspension containing surface-modified silver nanoparticles.

The resulting suspension was cooled, and then 120 g of methanol (available from Wako Pure Chemical Industries, Ltd.) was added thereto and stirred. Then, the surface-modified silver nanoparticles were precipitated by centrifugation, and the supernatant was removed. To the surface-modified silver nanoparticles, 120 g of dipropylene glycol n-butyl ether (reagent available from Tokyo Chemical Industry Co., Ltd.) was added and stirred. Then, the surface-modified silver nanoparticles were precipitated by centrifugation, and the supernatant was removed. Surface-modified silver nanoparticles (1), in a wet state, containing dipropylene glycol n-butyl ether were thus obtained. The content of the surface-modified silver nanoparticles in the total amount (100 wt.%) of the wet-state surface-modified silver nanoparticles was 90 wt.%, from results of a thermal balance using TG/DTA 6300 available from SII. That is, the wet-state surface-modified silver nanoparticles contained 10 wt.% dipropylene glycol n-butyl ether.

The wet-state surface-modified silver nanoparticles (1) were observed using a scanning electron microscope (JSM-6700F available from JEOL Ltd.). Particle sizes of ten silver nanoparticles optionally selected in an SEM photograph were determined, and an average value thereof was defined as an average particle size. The average particle size (primary particle size) of the silver nanoparticle portion in the surface-modified silver nanoparticles was approximately 50 nm.

### Example 1 (Preparation of silver ink)

A liquid A was prepared by adding THA-70, EC300,vinyl acetate, and polyvinyl butyral at a ratio shown in Table 1, stirring them for three hours with an oil bath (100 rpm), and then stirring and kneading (2 min × three times) the mixture with a rotation/revolution kneader (available from Kurabo Industries Ltd., Mazerustar KKK2508).

A black brown silver ink was obtained by adding the liquid A to the wet-state surface-modified silver nanoparticles (1) obtained in Preparative Example 1 (containing 10 wt.% of dipropylene glycol n-butyl ether), and stirring (2 min × three times) and kneading them with the rotation/revolution kneader (available from Kurabo Industries Ltd., Mazerustar KKK2508).

Examples 2 to 5 and Comparative Examples 1 to 3

The same procedure as in Example 1 was performed with the exception that the formulations were changed as shown in the table below (unit: parts by weight).

The substrate adhesion and electrical conductivity of each of sintered bodies of the silver inks obtained in the Examples and the Comparative Examples were evaluated by the following method.

Viscosity

The shear viscosity (mPa•s, 25°C) at 25°C and a shear rate of 10 (1/s) of each of the silver inks obtained in the Examples and the Comparative Examples was measured using a viscoelastic measuring device (trade name "Anton Paar Physica MCR 301", available from Anton Paar GmBH).

Evaluation of substrate adhesion of sintered body

The silver inks obtained in the Examples and the Comparative Examples were each applied onto an alkali-free glass sheet to form a coating film. The formed coating film was sintered at 120°C for 30 minutes using a hot plate to obtain a sintered body having a thickness of approximately 1 μm.

A tape peeling test (according to JIS K 5600) was performed on the obtained sintered body/alkali-free glass sheet laminates. The proportion of the sintered body remaining on the alkali-free glass sheet (residual rate: %) at the time of peeling the tape was calculated, and the substrate adhesion was evaluated based on the following criteria.

Evaluation Criteria

Good: The residual rate is greater than 90%
Poor: The residual rate is 90% or less

Evaluation of electrical conductivity of sintered body

The surface resistivity of the sintered body obtained in the same manner as in the substrate adhesion evaluation of the sintered body was measured using a four-terminal method (Loresta GP MCP-T610), and the volume resistivity was calculated from the following formula.

$$\text{Volume resistivity } (\mu\Omega\text{cm}) = \text{surface resistivity} \times \text{film thickness}$$

[Table 1]

Table 1

| | | Example 1 | Example 2 | Example 3 | Example 4 | Example 5 | Comparative Example 1 | Comparative Example 2 | Comparative Example 3 |
|---|---|---|---|---|---|---|---|---|---|
| Surface-modified silver nanoparticles | wt% | 71.29% | 72.00% | 71.29% | 72.00% | 72.00% | 71.29% | 71.29% | 72.00% |
| DPNB | wt% | 7.13% | 7.20% | 7.13% | 7.20% | 7.20% | 7.13% | 7.13% | 7.20% |
| THA-70 | wt% | 18.61% | 18.00% | 17.82% | 16.40% | 16.90% | 19.31% | 18.32% | 18.80% |
| EC300 | wt% | | 0.80% | 0.79% | 0.40% | 0.40% | 0.79% | 0.79% | 0.20% |
| Polyvinyl acetate | wt% | 1.49% | 1.50% | 1.49% | 200% | 200% | | 1.49% | 0.80% |
| SV-22 | wt% | 0.50% | 0.50% | 0.50% | 200% | 1.50% | 0.50% | | 1.00% |
| BYK322 | wt% | 0.99% | | 0.99% | | | 0.99% | 0.99% | 1.00% |
| | | 1000% | 1000% | 1000% | 1000% | 1000% | 1000% | 1000% | 101.0% |
| Polyvinyl acetate/surface-modified silver nanoparticles | | 0.02 | 0.02 | 0.02 | 0.03 | 0.03 | | 0.02 | 001 |
| S V-22/surface-modified silver nanoparticles | | 0.01 | 0.01 | 0.01 | 0.03 | 0.02 | 0.01 | | 0.01 |
| Polyvinyl acetate/SV-22 | | 3.00 | 3.00 | 300 | 1.00 | 1.33 | | | 0.80 |
| Viscosity | Pa•s (10 [1/s]) | 34.2 | 106.0 | 101.0 | 109.0 | 122.0 | 66.4 | 95.1 | 500 |
| Adhesion | | Good | Good | Good | Good | Good | Poor | Poor | Poor |
| Electrical conductivity | μΩcm | 100 | 9.9 | 17.4 | 44.9 | 27.9 | 7.0 | 8.7 | 11.5 |

The components listed in the table are as follows.

DPNB: Dipropylene glycol n-butyl ether, trade name: "DOWANOL DPnB", available from The Dow Chemical Company
THA-70: 4-(1'-acetoxy-1'-methylester)-cyclohexanol acetate, trade name: "Terusolve THA-70" available from NIPPON TERPENE CHEMICALS, INC., boiling point: 223°C, viscosity: 198 mPa•s
EC 300: Ethylcellulose resin, trade name: "ETHOCEL std. 300 (ETHOCEL™, std. 300)", available from The Dow Chemical Company
Polyvinyl acetate: Mw100,000 type available from Aldrich
SV-22:Polyvinyl butyral, trade name: S-LEC SV-22", available from Sekisui Chemical Co., Ltd.
BYK 322: Surface energy modifier, aralkyl-modified polymethylalkylsiloxane, trade name: BYK 322", available from BYK-Chemie GmbH

It can be seen from Table 1 that the electrically conductive ink containing surface-modified silver nanoparticles includes both polyvinyl acetate and polyvinyl acetal can form a sintered body having excellent adhesion even to a substrate having excellent solvent resistance and surface smoothness, such as a glass substrate.
Variations of embodiments of the present disclosure described above are additionally described below.

[1] An electrically conductive ink containing Components (A), (B), (C), and (D) below, wherein a ratio of Component (C) to Component (D) (Component (C)/Component (D)) is 1 or greater:

Component (A): a surface-modified metal nanoparticle having a configuration in which the surface of the metal nanoparticle (Component a-1) is coated with an organic protective agent (Component a-2);
Component (B): a solvent;
Component (C): polyvinyl acetate; and
Component (D): polyvinyl acetal.

[2] The electrically conductive ink according to [1], wherein a proportion of the organic protective agent (Component a-2) is from 1 to 20 wt.% (preferably, from 1 to 10 wt.%) of a weight of the metal nanoparticle (Component a-1).
[3] The electrically conductive ink according to [1] or [2], wherein the metal nanoparticle (Component a-1) has an average primary particle size from 0.5 to 100 nm (preferably from 0.5 to 80 nm, more preferably from 1 to 70 nm, and even more preferably from 1 to 60 nm).
[4] The electrically conductive ink according to any one of [1] to [3], wherein a metal that constitutes the metal nanoparticle (Component a-1) is at least one type (preferably, silver) selected from the group consisting of gold, silver, copper, nickel, aluminum, rhodium, cobalt, and ruthenium.
[5] The electrically conductive ink according to any one of [1] to [4], wherein Component (a-1) is a silver nanoparticle.
[6] The electrically conductive ink according to any one of [1] to [5], wherein Component (a-2) is a compound having at least one type of functional group (preferably, an amino group) selected from the group consisting of a carboxyl group, a hydroxyl group, an amino group, a sulfo group, and a thiol group.
[7] The electrically conductive ink according to any one of [1] to [6], wherein Component (a-2) is a compound having at least an amino group (preferably, a compound having from 4 to 18 carbon atoms and having an amino group).
[8] The electrically conductive ink according to any one of [1] to [7], wherein Component (B) contains a terpene solvent (Component b-1).
[9] The electrically conductive ink according to [8], wherein Component (b-1) is a terpene solvent having a boiling point of 130°C or higher (for example, from 130 to 300°C, and preferably from 200 to 300°C) and has a viscosity (at 20°C) from 50 to 250 mPa•s (particularly preferably from 100 to 250 mPa•s, and most preferably from 150 to 250 mPa•s).
[10] The electrically conductive ink according to any one of [1] to [9], wherein Component (B) contains a glycol solvent (Component b-2).
[11] The electrically conductive ink according to [10], wherein Component (b-2) includes a solvent selected from the group consisting of a glycol ether solvent and a glycol ester solvent.
[12] The electrically conductive ink according to [10] or [11], wherein Component (b-2) includes a compound represented by Formula (b-2-1) below: $R^{n}\text{-}(O\text{-}R^{13})_m\text{-}OR^{12}$ (b-2-1)
where $R^{11}$ and $R^{12}$ are identical or different and represent alkyl or acyl groups, $R^{13}$ represents an alkylene group having from 1 to 6 carbon atoms, and m represents an integer of 1 or greater.
[13] The electrically conductive ink according to [12], wherein a boiling point of the compound represented by Formula (b-2-1) above is 130°C or higher (preferably from 130 to 300°C, more preferably 170°C or higher, and particularly preferably 200°C or higher).

[14] The electrically conductive ink according to any one of [11] to [13], wherein the glycol ether solvent contains a compound (glycol monoether) represented by Formula (b-2-1') below:

$$R^{14}\text{-}(O\text{-}R^{15})_n\text{-}OH \quad \text{(b-2-1')}$$

where $R^{14}$ represents an alkyl group or an aryl group, $R^{15}$ represents an alkylene group having from 1 to 6 carbon atoms, and n is an integer of 1 or greater).

[15] The electrically conductive ink according to [14], wherein the compound represented by Formula (b-2-1') has a boiling point of 130°C or higher (for example, from 130 to 310°C, preferably from 130 to 250°C, particularly preferably from 130 to 200°C, most preferably from 130 to 180°C, and especially preferably from 140 to 180°C).

[16] The electrically conductive ink according to any one of [11] to [15], wherein the glycol ester solvent contains a compound represented by Formula (b-2-2) below:

$$R^{16}O\text{-}(R^{18}O)_{m'}\text{-}R^{17} \quad \text{(b-2-2)}$$

where $R^{16}$ represents a hydrogen atom, an alkyl group, an aryl group, or an acyl group, $R^{17}$ represents an acyl group, $R^{18}$ represents an alkylene group, and m' represents an integer of 1 or greater.

[17] The electrically conductive ink according to any one of [1] to [16], wherein a weight average molecular weight of Component (C) (according to GPC calibrated with polystyrene standards) is 200,000 or less (preferably from 50,000 to 180,000, and more preferably from 50,000 to 150,000).

[18] The electrically conductive ink according to any one of [1] to [17], wherein the polyvinyl acetate (C) has a glass transition temperature (Tg) from 25 to 35°C (preferably from 26 to 32°C, and more preferably from 28 to 30°C).

[19] The electrically conductive ink according to any one of [1] to [18], wherein a viscosity of a 4 wt.% aqueous solution of the polyvinyl acetate (C) (measurement temperature: 20°C) is from 1.5 to 80 mPa•s (preferably from 5 to 70 mPa•s, and particularly preferably from 10 to 60 mPa•s).

[20] The electrically conductive ink according to any one of [1] to [19], wherein Component (D) contains carboxylic acid-modified polyvinyl acetal (preferably, carboxylic acid-modified polyvinyl butyral).

[21] The electrically conductive ink according to any one of [1] to [20], wherein Component (D) contains polyvinyl butyral.

[22] The electrically conductive ink according to any one of [1] to [21], wherein a weight average molecular weight of Component (D) (according to GPC calibrated with polystyrene standards) is 200,000 or less (preferably from $0.1 \times 10^4$ to $20.0 \times 10^4$, even more preferably from $0.5 \times 10^4$ to $20.0 \times 10^4$, even more preferably from 0.5 to $10^4$ to $10.0 \times 10^4$, most preferably from $0.5 \times 10^4$ to $5.0 \times 10^4$, and particularly preferably from $0.5 \times 10^4$ to $3.0 \times 10^4$).

[23] The electrically conductive ink according to any one of [1] to [22], wherein the polyvinyl acetal (D) has a glass transition temperature (Tg) from 50 to 75°C (preferably from 55 to 70°C, and even more preferably from 58 to 68°C).

[24] The electrically conductive ink according to any one of [1] to [23], wherein a viscosity of a 10 wt.% ethanol solution of the polyvinyl acetal (D) (measurement temperature: 20°C) is from 5 to 30 mPa•s (preferably from 7 to 20 mPa•s, and particularly preferably from 9 to 15 mPa•s).

[25] The electrically conductive ink according to any one of [1] to [24], which containing a surface energy modifier (E).

[26] The electrically conductive ink according to [25], wherein the surface energy modifier (E) is at least one type (preferably a silicone-based surface energy modifier) selected from the group consisting of a silicone-based surface energy modifier, an acrylic surface energy modifier, a fluorine-based surface energy modifier, and a vinyl-based surface energy modifier.

[27] The electrically conductive ink according to [25] or [26], wherein a content of the surface energy modifier (E) is from 0.1 to 5.0 wt.% (preferably from 0.5 to 3.0 wt.%) of a total amount of the electrically conductive ink.

[28] The electrically conductive ink according to any one of [25] to [27], wherein a content of the surface energy modifier (E) is from 0.5 to 5.0 parts by weight (preferably from 1.0 to 3.0 parts by weight) relative to 100 parts by weight of the surface-modified metal nanoparticles (A).

[29] The electrically conductive ink according to any one of [1] to [28], further containing a binder resin (F).

[30] The electrically conductive ink according to [29], wherein the binder resin (F) is at least one type (preferably a cellulosic resin, and more preferably an ethyl cellulose) selected from the group consisting of a vinyl chloride-vinyl acetate copolymer resin, a polyester resin, an acrylic resin, and a cellulosic resin.

[31] The electrically conductive ink according to [29] or [30], wherein a content of the binder resin (F) is from 0.1 to 5.0 wt.% (preferably from 0.3 to 3.0 wt.%) of a total amount of the electrically conductive ink.

[32] The electrically conductive ink according to any one of [1] to [31], wherein a content of the surface-modified metal nanoparticles (A) in the total amount (100 wt.%) of the electrically conductive ink is from 60 to 85 wt.% (a lower limit thereof is preferably 70 wt.%; and an upper limit thereof is preferably 80 wt.%, and particularly preferably 75 wt.%).

[33] The electrically conductive ink according to any one of [1] to [32], wherein a content of the solvent (B) in the total amount (100 wt.%) of the electrically conductive ink is from 5 to 45 wt.% (a lower limit thereof is preferably 10 wt.%, and more preferably 20 wt.%; and an upper limit thereof is preferably 40 wt.%, and particularly preferably 35 wt.%).
[34] The electrically conductive ink according to any one of [1] to [33], wherein Component (B) is contained in an amount from 30 to 60 parts by weight (a lower limit thereof is preferably 31 parts by weight, and more preferably 33 parts by weight; and an upper limit thereof is preferably 50 parts by weight, and particularly preferably 45 parts by weight) relative to 100 parts by weight of Component (A).
[35] The electrically conductive ink according to any one of [8] to [34], wherein a content of the terpene solvent (Component b-1) in the total amount (100 wt.%) of the electrically conductive ink is from 5 to 30 wt.% (a lower limit thereof is preferably 10 wt.%, and more preferably 14 wt.%; and an upper limit thereof is preferably 25 wt.%, and more preferably 23 wt.%).
[36] The electrically conductive ink according to any one of [8] to [35], wherein a content of the terpene solvent (Component b-1) is from 10 to 50 parts by weight (a lower limit thereof is preferably from 15 parts by weight, and more preferably 20 parts by weight; and an upper limit thereof is preferably 40 parts by weight, and more preferably 35 parts by weight) relative to 100 parts by weight of the surface-modified metal nanoparticles (A).
[37] The electrically conductive ink according to any one of [10] to [36], wherein a content of the glycol solvent (Component b-2) (in particular, a compound represented by Formula (b-2-1)) in the total amount (100 wt.%) of the electrically conductive ink is from 1 to 15 wt.% (a lower limit thereof is preferably 2 wt.%, and more preferably 5 wt.%; and an upper limit thereof is preferably 10 wt.%, and more preferably 8 wt.%).
[38] The electrically conductive ink according to any one of [10] to [37], wherein a content of the glycol solvent (Component b-2) (in particular, the compound represented by Formula (b-2-1) is from 1 to 20 parts by weight (a lower limit thereof is preferably 2 parts by weight, and more preferably 5 parts by weight; and an upper limit thereof is preferably 15 parts by weight, and more preferably 12 parts by weight) relative to 100 parts by weight of the surface-modified metal nanoparticles (A).
[39] The electrically conductive ink according to any one of [10] to [38], wherein a ratio of the terpene solvent (b-1) to the glycol solvent (b-2) (terpene solvent (b-1)/glycol solvent (b-2)) is from 0.1 to 10 (a lower limit thereof is preferably 0.5, more preferably 1, and even more preferably 2; and an upper limit thereof is preferably 8, more preferably 7, and even more preferably 5).
[40] The electrically conductive ink according to any one of [1] to [39], wherein a content of the polyvinyl acetate (C) in the total amount of the electrically conductive ink (100 wt.%) is from 0.1 to 10 wt.% (a lower limit thereof is preferably from 0.5 wt.%, and more preferably 1 wt.%; and an upper limit thereof is preferably 5 wt.%, and particularly preferably 3 wt.%).
[41] The electrically conductive ink according to any one of [1] to [40], wherein Component (C) is contained in an amount from 0.5 to 5 parts by weight (a lower limit thereof is preferably 1 part by weight, and more preferably 1.3 parts by weight; and an upper limit thereof is preferably 4 parts by weight, and more preferably 3 parts by weight), relative to 100 parts by weight of Component (A).
[42] The electrically conductive ink according to any one of [1] to [41], wherein a content of the polyvinyl acetal (D) in the total amount of the electrically conductive ink (100 wt.%) is from 0.1 to 5 wt.% (a lower limit thereof is preferably from 0.2 wt.%, and more preferably 0.3 wt.%; and an upper limit thereof is preferably 3 wt.%, and particularly preferably 1 wt.%).
[43] The electrically conductive ink according to any one of [1] to [42], wherein Component (D) is contained in an amount from 0.1 to 2 parts by weight (a lower limit thereof is preferably 0.3 parts by weight, and more preferably 0.5 parts by weight; and an upper limit thereof is preferably 1.5 parts by weight, and more preferably 1 parts by weight) relative to 100 parts by weight of Component (A).
[44] The electrically conductive ink according to any one of [1] to [43], wherein the ratio of Component (C) to Component (D) (Component (C)/Component (D)) is from 1 to 10 (a lower limit thereof is preferably 1.3, and even more preferably 1.5; and an upper limit thereof is preferably 7, and more preferably 5).
[45] The electrically conductive ink according to any one of [1] to [44], wherein a viscosity at 25°C and a shear rate of 10 (1/s) of the electrically conductive ink is 60 Pa•s or greater (a lower limit thereof is preferably 70 Pa•s, more preferably 80 Pa•s, even more preferably 90 Pa•s, even more preferably 100 Pa•s, and particularly preferably 150 Pa•s.; and an upper limit thereof is preferably 500 Pa•s, more preferably 450 Pa•s, particularly preferably 400 Pa•s, and most preferably 350 Pa•s).
[46] The electrically conductive ink according to any one of [1] to [45], wherein a viscosity at 25°C and a shear rate of 100 (1/s) of the electrically conductive ink is from 10 to 100 Pa•s (an upper limit thereof is preferably 80 Pa•s, particularly preferably 60 Pa•s, most preferably 50 Pa•s, and especially preferably 40 Pa•s.; and a lower limit thereof is preferably 15 Pa•s, particularly preferably 20 Pa•s, most preferably 25 Pa•s, and especially preferably 30 Pa•s).
[47] The electrically conductive ink according to any one of [1] to [46], wherein a TI value at 25°C of the electrically

conductive ink (the viscosity at a shear rate of 10 (1/s)/the viscosity at a shear rate of 100 (1/s)) is from 3.0 to 10.0 (preferably from 3.5 to 7.0, particularly preferably from 4.0 to 6.5, most preferably from 4.5 to 6.3, and especially preferably from 4.8 to 6.2).

[48] The electrically conductive ink according to any one of [1] to [47], wherein a coating film adhesion obtained by applying the electrically conductive ink to a glass substrate and sintering the electrically conductive ink at 120°C for 30 minutes is 90% or greater (preferably 95% or greater) in a tape peeling test (in accordance with JIS K 5600).

[49] A method for manufacturing an electronic device, the method including applying the electrically conductive ink described in any one of [1] to [48] onto a substrate by a printing method; and sintering the electrically conductive ink.

[50] The method for manufacturing an electronic device according to [49], wherein the printing method is screen printing, offset printing, flexographic printing, gravure printing, or ink jet printing (preferably screen printing).

[51] An electronic device including a sintered body of the electrically conductive ink described in any one of [1] to [48] on a substrate.

Industrial Applicability

The use of the electrically conductive ink of the present disclosure enables to form a sintered body having excellent adhesion even to a substrate having excellent solvent resistance and surface smoothness, such as a glass substrate, by printing. Furthermore, a sintered body having excellent electrical conductivity is obtained by applying the ink of the present disclosure and then sintering it. Therefore, the electrically conductive ink of the present disclosure can be suitably used in applications of manufacturing an electronic component on a glass substrate using a printing method.

## Claims

**1.** An electrically conductive ink comprising Components (A), (B), (C), and (D) below, wherein a ratio of Component (C) to Component (D) (Component (C)/Component (D)) is 1 or greater:

Component (A): a surface-modified metal nanoparticle having a configuration in which the surface of the metal nanoparticle (Component a-1) is coated with an organic protective agent (Component a-2);
Component (B): a solvent;
Component (C): polyvinyl acetate; and
Component (D): polyvinyl acetal.

**2.** The electrically conductive ink according to claim 1, wherein from 30 to 60 parts by weight of Component (B), from 1 to 5 parts by weight of Component (C), and from 0.1 to 2 parts by weight of Component (D) are contained relative to 100 parts by weight of Component (A).

**3.** The electrically conductive ink according to claim 1 or 2, wherein the ratio of Component (C) to Component (D) (Component (C)/Component (D)) is from 1 to 10.

**4.** The electrically conductive ink according to any one of claims 1 to 3, wherein Component (a-2) is a compound having at least one type of functional group selected from the group consisting of a carboxyl group, a hydroxyl group, an amino group, a sulfo group, and a thiol group.

**5.** The electrically conductive ink according to any one of claims 1 to 4, wherein Component (B) contains a terpene solvent (Component b-1).

**6.** The electrically conductive ink according to claim 5, wherein Component (b-1) is a terpene solvent having a boiling point of 130°C or higher and has a viscosity (at 20°C) from 50 to 250 mPa•s.

**7.** The electrically conductive ink according to any one of claims 1 to 6, wherein Component (B) contains a glycol solvent (Component b-2).

**8.** The electrically conductive ink according to claim 7, wherein Component (b-2) comprises a solvent selected from the group consisting of a glycol ether solvent and a glycol ester solvent having a boiling point of 130°C or higher.

**9.** The electrically conductive ink according to claim 8, wherein Component (b-2) comprises a compound represented by Formula (b-2-1) below:

$R^n-(O-R^{13})_m-OR^{12}$ (b-2-1)

wherein $R^{11}$ and $R^{12}$ are identical or different and represent alkyl or acyl groups, $R^{13}$ represents an alkylene group having from 1 to 6 carbon atoms, and m represents an integer of 1 or greater.

**10.** The electrically conductive ink according to any one of claims 1 to 9, wherein Component (C) has a weight average molecular weight of 200,000 or less (according to GPC calibrated with polystyrene standards).

**11.** The electrically conductive ink according to any one of claims 1 to 10, wherein Component (D) has weight average molecular weight of Component (D) (according to GPC calibrated with polystyrene standards) is 200,000 or less.

**12.** The electrically conductive ink according to any one of claims 1 to 11, wherein Component (D) contains carboxylic acid-modified polyvinyl acetal.

**13.** The electrically conductive ink according to any one of claims 1 to 12, wherein Component (D) contains polyvinyl butyral.

**14.** The electrically conductive ink according to any one of claims 1 to 13, wherein Component (D) contains carboxylic acid-modified polyvinyl butyral.

**15.** The electrically conductive ink according to any one of claims 1 to 14, further comprising a binder resin (F).

**16.** The electrically conductive ink according to any one of claims 1 to 15, wherein a coating film adhesion obtained by applying the electrically conductive ink to a glass substrate and sintering the electrically conductive ink at 120°C for 30 minutes is 90% or greater in a tape peeling test (in accordance with JIS K 5600).

**17.** The electrically conductive ink according to any one of claims 1 to 16, wherein Component (a-1) is a silver nanoparticle.

**18.** A method for manufacturing an electronic device, the method comprising applying the electrically conductive ink described in any one of claims 1 to 17 onto a substrate by a printing method, and sintering the electrically conductive ink.

**19.** The method for manufacturing an electronic device according to claim 18, wherein the printing method is screen printing.

**20.** An electronic device comprising a sintered body of the electrically conductive ink described in any one of claims 1 to 17 on a substrate.

## INTERNATIONAL SEARCH REPORT

International application No.
PCT/JP2021/025306

A. CLASSIFICATION OF SUBJECT MATTER
Int. Cl. C09D11/52(2014.01)i, H01B1/00(2006.01)i, H01B1/22(2006.01)i, H01B13/00(2006.01)i
FI: H01B1/22 A, H01B1/00 E, H01B13/00 503D, H01B13/00 503Z, C09D11/52
According to International Patent Classification (IPC) or to both national classification and IPC

B. FIELDS SEARCHED
Minimum documentation searched (classification system followed by classification symbols)
Int. Cl. C09D11/52, H01B1/00, H01B1/22, H01B13/00

Documentation searched other than minimum documentation to the extent that such documents are included in the fields searched
Published examined utility model applications of Japan 1922-1996
Published unexamined utility model applications of Japan 1971-2021
Registered utility model specifications of Japan 1996-2021
Published registered utility model applications of Japan 1994-2021

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | WO 2017/175661 A1 (DAICEL CORP.) 12 October 2017 (2017-10-12), claims | 1-20 |
| A | JP 2016-121241 A (SHOWA DENKO KABUSHIKI KAISHA) 07 July 2016 (2016-07-07), paragraph [0081], table 1 | 1-20 |

☐ Further documents are listed in the continuation of Box C.  ☒ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 07.09.2021 | 14.09.2021 |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

**INTERNATIONAL SEARCH REPORT**
Information on patent family members

International application No.
PCT/JP2021/025306

| Patent Documents referred to in the Report | Publication Date | Patent Family | Publication Date |
|---|---|---|---|
| WO 2017/175661 A1 | 12.10.2017 | US 2019/0119519 A1<br>claims<br>EP 3441435 A1<br>CN 108884346 A<br>KR 10-2018-0128476 A<br>TW 201807083 A | |
| JP 2016-121241 A | 07.07.2016 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2020118059 A
- WO 2017175661 A